# EUROPÄISCHE PATENTSCHRIFT

(11) **EP 1 488 514 B1**
(45) Veröffentlichungstag und Bekanntmachung des Hinweises auf die Patenterteilung: **11.06.2008**
(21) Anmeldenummer: 03724848.1
(22) Anmeldetag: 25.03.2003
(51) Int. Cl.: H03H 9/64

(54) **FILTER MIT AKUSTISCH GEKOPPELTEN RESONATOREN**
FILTER COMPRISING ACOUSTICALLY COUPLED RESONATORS
FILTRE COMPORTANT DES RESONATEURS COUPLES DE FACON ACOUSTIQUE

(30) Priorität: 25.03.2002 DE 10213277
(43) Veröffentlichungstag der Anmeldung: 22.12.2004
(73) Patentinhaber: EPCOS AG, 81669 München (DE)
(72) Erfinder: BAUER, Thomas, 81739 München (DE); HASHIMOTO, Ken-ya, Funabashi-shi, Chiba 274-0806 (JP); ROESLER, Ulrike, 85435 Erding (DE); RUILE, Werner, 80636 München (DE); MEISTER, Veit, 15345 Kagel (DE); KUHRAU, Heide, 81369 München (DE); JAKOB, Michael, 81541 München (DE)
(74) Vertreter: Epping - Hermann - Fischer
(86) Internationale Anmeldenummer: PCT/DE2003/000980
(87) Internationale Veröffentlichungsnummer: WO 2003/081773

(56) Entgegenhaltungen:
- EP-A- 1 246 359
- EP-A- 1 280 274
- WO-A-01/65687
- US-A- 5 499 003

## Beschreibung

Die Erfindung betrifft ein mit oberflächennahen akustischen Wellen arbeitendes Bauelement, insbesondere ein Filter mit einer Netzwerkstruktur, in die Resonatoren eingebettet sind.

Das dokument US-A-5 499 003 veröffentlicht ein Beispiel eine solcher Filters.

Im Frontend von Endgeräten mobiler Kommunikation, beispielsweise in Mobiltelefonen, werden als Bandpassfilter im HF-Bereich heute überwiegend SAW-Filter eingesetzt. Diese sind im wesentlichen als Reaktanz- oder DMS-Filter ausgebildet.

Bekannt sind auch Verschaltungen von DMS-Filtern mit Reaktanzelementen, insbesondere mit in SAW-Technik ausgeführten Eintor-Resonatoren. So ist beispielsweise aus der DE 198 18 038 A ein DMS-Filter bekannt, bei dem zwei seriell oder parallel verschaltete DMS-Filter in Serie ein- oder ausgangsseitig mit Reaktanzelementen verschaltet sind. Außerdem wird dort vorgeschlagen, beide DMS-Filter innerhalb einer akustischen Spur anzuordnen und zwei benachbarte DMS-Filter durch dazwischenliegende Reflektoren zu trennen.

Weitere bekannte Filter sind auch Zweitorresonatoren, die wegen ihrer schmalbandigen Übertragungseigenschaften aber nur selten im HF-Bereich angewendet werden können.

Je nach gewünschtem Eigenschaftsprofil kann eine der Techniken bevorzugt sein. Beispielsweise werden bei eng benachbarten Frequenzbändern zur Selektion höhere Anforderungen an die Flankensteilheit derjenigen Passbandflanke gestellt, die zum jeweils benachbarten Frequenzband abgrenzt. Unterschiedliche Flanken können unterschiedliche Techniken bevorzugen. Reaktanzfilter zeichnen sich zusätzlich durch höhere Leistungsfestigkeit aus. Ein gewünschtes anspruchsvolles Eigenschaftsprofil für ein HF-Filter insbesondere für neue Übertragungstechniken, kann oft mit bekannten "reinen" Techniken nicht mehr realisiert werden. So tritt beispielsweise bei Reaktanzfiltern im Durchlaßbereich ein unerwünschtes "Ripple" auf, das von der endlichen Länge des Serienresonators herrührt. Ebenso ist aufgrund der endlichen Länge der bei Reaktanzfiltern verwendeten Resonatoren die Einfügedämpfung erhöht.

Aus der US 5,486,800 C1 ist es bekannt, mehrere identische Interdigitalwandler einander direkt benachbart innerhalb nur einer akustischen Spur so hintereinander anzuordnen, daß eine akustische Kopplung der Interdigitalwandler erfolgt. Die Interdigitalwandler sind elektrisch in Serie geschaltet, wobei zwischen jeweils zwei Interdigitalwandlern ein gegen Masse geschalteter Parallelzweig abzweigt. In der Art einer Laddertypestruktur ist in jedem Parallelzweig ein weiterer paralleler Interdigitalwandler angeordnet. Auch können mehrere parallele Interdigitalwandler innerhalb einer akustischen Spur angeordnet sein und ebenfalls akustisch gekoppelt sein. Jede Spur mit akustisch gekoppelten Interdigitalwandlern kann beiderseits von je einem akustischen Reflektor begrenzt sein.

Aufgabe der vorliegenden Erfindung ist es daher, neue Strukturen für mit oberflächennahen akustischen Wellen arbeitende Bauelemente anzugeben, mit denen sich Filter mit weiter verbesserte Eigenschaften erhalten lassen.

Diese Aufgabe wird erfindungsgemäß mit einem Bauelement nach Anspruch 1 gelöst. Vorteilhafte Ausgestaltungen der Erfindung sind den Unteransprüchen zu entnehmen.

Die Erfindung schlägt ein Bauelement mit folgenden Merkmalen vor:
auf der Oberfläche eines piezoelektrischen Substrats sind zumindest drei Interdigitalwandler angeordnet, die jeweils mit einem ersten und einem zweiten elektrischen Anschluß versehen und über diese Anschlüsse elektrisch miteinander verschaltet sind,
- in mindestens einem als Signalpfad dienenden seriellen Zweig, der den Eingang und den Ausgang des Bauelements verbindet und in dem alle darin enthaltenen Elemente elektrisch in Serie geschaltet sind, ist zumindest ein serieller Interdigitalwandler angeordnet
- zumindest ein paralleler Zweig, in dem ein paralleler Interdigitalwandler angeordnet ist, ist parallel dazu gegen ein Bezugspotential geschaltet,
- zumindest zwei Interdigitalwandler sind in Ausbreitungsrichtung der akustischen Welle hintereinander so angeordnet, daß sie akustisch miteinander gekoppelt sind, wobei die beiden genannten akustisch miteinander koppelnden Wandler nicht gleichzeitig einen seriellen Interdigitalwandler umfassen, bauartgleich sind und elektrisch direkt miteinander verbunden sind.

In vorteilhaften Ausführungen sind die beiden akustisch miteinander koppelnden Wandler unterschiedlich und weisen zumindest eines der folgenden Merkmale auf :
a) die Interdigitalwandler weisen unterschiedliche Apertur auf
b) die Interdigitalwandler weisen einen unterschiedlichen Pitch auf
c) die Interdigitalwandler weisen unterschiedliche Anzahl von interdigitalen Elektrodenfingern auf
d) die Interdigitalwandler weisen eine unterschiedliche Metallisierungstärke auf
e) die Interdigitalwandler sind gewichtet und weisen eine unterschiedliche Wichtung auf.

Mit der Erfindung wird von der aus der US 5,486,800 bekannten streng regelmäßigen Laddertypestruktur abgewichen und die Symmetrie bewußt gestört, um weitere vorteilhafte Effekte zu erzielen. Während die bekannte Laddertypestruktur einem Wellenparameterdesign gehorcht, beruht ein erfindungsgemäßes Bauelement auf einem Betriebsparameterdesign. Es erlaubt eine völlig neuartige Filterstruktur, die sich neben vielen neuen Eigenschaften vor allem auch durch einen geringeren Platzbedarf (Chipfläche) auszeichnet. In allen Ausführungsbeispielen entfällt zumindest die regelmäßige Abzweigung von Parallelzweigen und das Erfordernis der jeweils im seriellen oder parallelen Zweig identisch aufgebauten Interdigitalwandler. Damit läßt sich ein Filterverhalten konstruieren, das über beliebig viele Polstellen verfügt, so bei beliebigen Frequenzen Sperrverhalten zeigt und insgesamt doch eine verbesserte Einfügedämpfung aufweist. Letzteres ist darauf zurückzuführen, daß durch die akustische Kopplung der Interdigitalwandler nur wenig Energie im Signalpfad verloren geht, da die aus einem einzelnen Interdigitalwandler austretende akustische Energie an anderer Stelle wieder in das System eingekoppelt werden kann.

Durch den zumindest teilweisen Wegfall der Reflektoren zwischen akustisch gekoppelten Interdigitalwandlern wird die oft überhöhte Leistungsdichte am Übergang zwischen Reflektor und Interdigitalwandler reduziert.

Durch die akustische Kopplung wird die akustische Länge der Interdigitalwandler erhöht und dabei die Randeffekte reduziert, ebenso die damit verbundene Welligkeit.

Bei akustisch gekoppelten Interdigitalwandlern wirkt der benachbarte (gekoppelte) Interdigitalwandler als Reflektor. Damit entfallen die Reflektorverluste, gleichzeitig wird die erforderliche Fläche für das Bauelement reduziert.

Durch die akustische Verkopplung verschiedener nicht im selben Zweig angeordneter Interdigitalwandler reduziert sich der Grad an erforderlicher Kaskadierung im Filter, es können gleichzeitig minimale Anzahl an Elektrodenfingern und eine kleinstmögliche Apertur eingehalten werden.

Durch die akustische Verkopplung gelingt die Einkopplung gegenphasiger Signale in einen Interdigitalwandler, womit die Stoppbandunterdrückung und/oder die Isolation in kritischen Frequenzbereichen erhöht wird.

Mit der Erfindung gelingt es, die Leistungsdichte innerhalb in den Elektrodenstrukturen der Interdigitalwandler zu reduzieren und zusätzliche nichtlineare Effekte zu unterdrücken, die zu unerwünschter Modulation führen.

Die Erfindung schlägt vor, auf der Oberfläche eines piezoelektrischen Substrats angeordnete, elektrisch miteinander verschaltete Interdigitalwandler auch akustisch miteinander zu verkoppeln. Dazu werden entweder in einem seriellen Zweig, der den Eingang und den Ausgang des Bauelements miteinander verbindet, zumindest zwei serielle Interdigitalwandler elektrisch in Serie geschaltet und akustisch gekoppelt, oder es werden die Interdigitalwandler von zumindest zwei parallelen Zweigen, zwischen denen ein serieller Zweig liegt, in dem ein oder mehrere Interdigitalwandler angeordnet sind, akustisch gekoppelt. Die akustische Kopplung der Interdigitalwandler geschieht durch eine in-line Anordnung innerhalb einer akustischen Spur. Möglich ist es auch, einen seriellen und einen parallelen Interdigitalwandler innerhalb einer Spur anzuordnen und akustisch miteinander zu koppeln.

Über diese Kopplung werden neue Eigenschaften des Bauelements realisiert, wobei sich das Maß der Kopplung zwischen den Interdigitalwandlern variieren und optimieren läßt.

Zwei akustisch miteinander gekoppelte Interdigitalwandler können direkt nebeneinander in einer akustischen Spur angeordnet sein. Die akustische Spur ist dabei vorteilhafterweise beiderseits von je einem Reflektor begrenzt, welcher jeweils ein regelmäßiges Streifenmuster von Reflektorstreifen umfaßt. Die Reflexionswirkung eines Reflektors ist dabei neben dem gewählten Substratmaterial von der Höhe, Breite und insbesondere von der Anzahl der Reflektorstreifen abhängig. Die Frequenzabhängige Reflexion des Reflektors wird durch den Abstand der Reflektorstreifen bestimmt, die sogenannte Fingerperiode, die entsprechend der Fingerperiode des oder der Interdigitalwandler gewählt wird. Die Anzahl der Reflektorstreifen in den Reflektoren ist vorzugsweise so hoch, daß im Durchlaßbereich des insbesondere als Filter ausgebildeten Bauelements nahezu vollständige Reflexion der akustischen Welle am Reflektor erfolgt. Ein beiderseits von Reflektoren begrenzter Interdigitalwandler stellt dann einen Resonator dar. Sind zwei Interdigitalwandler nebeneinander angeordnet und beiderseits von Reflektoren begrenzt, so erhält man einen Zweitorresonator mit zwei elektrischen Toren. In einer Spur kann eine beliebige Anzahl von Interdigitalwandler angeordnet und gekoppelt sein.

Möglich ist jedoch auch, die Interdigitalwandler eines Typs (seriell oder parallel) in unterschiedlichen Spuren anzuordnen. Dabei kann Kopplung parallel in unterschiedlichen Spuren erfolgen. Auf diese Weise ist auch möglich, daß solche Interdigitalwandler miteinander koppeln, die nicht direkt elektrisch miteinander verschaltet sind, beispielsweise zwei serielle Interdigitalwandler, zwischen denen in der Verschaltung zumindest ein weiterer serieller Interdigitalwandler angeordnet ist. Auch können parallele Interdigitalwandler gekoppelt werden, die in nicht direkt benachbarten parallelen Zweigen angeordnet sind. Auch die Verkopplung eines parallelen und eines seriellen Interdigitalwandlers ist möglich.

Möglich ist es jedoch auch, sämtliche Interdigitalwandler eines Typs (seriell oder parallel) akustisch miteinander zu koppeln. Innerhalb eines Typs von Interdigitalwandlern können aber auch gekoppelte und ungekoppelte Interdigitalwandler nebeneinander vorliegen.

Die Art und Stärke der Kopplung zwischen zwei Interdigitalwandlern kann mittels unterschiedlicher Möglichkeiten beeinflußt werden:
a) Zwischen den koppelnden Interdigitalwandlern können teildurchlässige Reflektoren oder
b) metallisierte Laufstrecken angeordnet werden.
c) Die Aperturen der koppelnden Interdigitalwandler werden unterschiedlich gewählt
d) An den miteinander koppelnden Interdigitalwandlern fällt eine unterschiedliche Spannung ab.
e) Zwischen den miteinander koppelnden Interdigitalwändlern wird ein Phasenunterschied eingestellt

In einer Ausgestaltung a) wird die akustische Kopplung benachbarter Interdigitalwandler durch akustisch teilweise durchlässige Zwischenreflektoren reduziert. Ein solcher Zwischenreflektor besteht aus einer Anzahl von n Reflektorstreifen, wobei n so gewählt ist, daß keine vollständige Reflexion erfolgt und eine akustische Kopplung der durch den Zwischenreflektor getrennten Interdigitalwandler möglich ist. Üblicherweise gilt für n: 0 ≤ n ≤ 100. Mit größer werdendem n wird die akustische Kopplung der durch den Zwischenreflektor getrennten Interdigitalwandler reduziert. Über eine geeignete Bemessung der Zahl n können damit die Eigenschaften der gekoppelten Interdigitalwandler und damit die Eigenschaften des gesamten Bauelements beeinflußt bzw. eingestellt werden, wobei im Grenzfall n = 0 kein Zwischenreflektor vorgesehen ist und die gekoppelten Interdigitalwandler einander direkt benachbart sind, wobei maximale Kopplung erhalten wird. Wird n von geradzahlig auf ungeradzahlig geändert, kann darüber hinaus die Phase der Kopplung um 180° variiert werden.

Eine Feinabstimmung der Phase der akustischen Kopplung kann durch eine Variation des Abstands der Interdigitalwandler untereinander oder zwischen den Interdigitalwandlern und den Reflektoren erfolgen, wobei eine DMS-Filtern ähnliche Struktur erhalten wird. Die Interdigitalwandler werden so gegeneinander verschoben, daß die Phase der akustischen Kopplung-zwischen beiden Interdigitalwandler einen Unterschied Δϕ aufweist mit -90°< Δϕ < 90°. Insbesondere können durch eine Variation des Abstands auch zusätzliche Resonanzen erzeugt werden, die ähnlich wie bei einem DMS Filter zur Formung der Filter-Übertragungsfunktion und der Flanken herangezogen werden können.

Der freie Abstand zwischen zwei Interdigitalwandlern kann auch mit einer ganz oder teilweise metallisierten Laufstrecke versehen sein, mit der neben der Kopplung die Geschwindigkeit der Oberflächenwelle beeinflusst oder die Ausbreitung der Oberflächenwelle oberflächennah gehalten werden kann.

Eine Varation der an einem Interdigitalwandler anliegenden Spannung gelingt durch Kaskadierung. Dabei wird ein Interdigitalwandler durch eine Serienschaltung von zwei oder allgemein m Resonatoren (m größer gleich 2) ersetzt. Bei gleichen Abstand der Stromschienen erhält man so eine Reduzierung der Spannung U auf einen Wert von U/m. Zwischenwerte werden erhalten, wenn man die Abstände der Stromschienen einzelner Interdigitalwandler innerhalb der Kaskadierung variiert. Damit wird die Leistungsdichte innerhalb der Interdigitalwandler reduziert und die akustisch wirksame Fläche erhöht. Eine Reduzierung der Leistungsdichte reduziert die Materialermüdung und das Auftreten von Fehlern und erhöht damit auch die Zuverlässigkeit und die Lebensdauer des Bauelements.

Die Kaskadierung kann quer zur Ausbreitungsrichtung der Oberflächenwelle erfolgen, wobei die kaskadierten Interdigitalwandler in verschiedenen akustischen Spuren angeordnet sein können.

Die Kaskadierung kann auch durch Serienverschaltung von in-line hintereinander angeordneten Interdigitalwandlern erfolgen.

Eine Kaskade kann auch ein- oder mehrfach gefaltet sein und so gleichzeitig sowohl nebeneinander in verschiedenen akustischen Spuren als auch hintereinander innerhalb einer akustischen Spur angeordnete Interdigitalwandler umfassen. In-line hintereinander angeordnete Interdigitalwandler innerhalb der gleichen oder in unterschiedlichen aber benachbarten Kaskaden können akustisch miteinander gekoppelt sein. Durch die Faltung entstehen u-förmige oder meanderförmige Anordnungen von Interdigitalwandlern.

Insbesondere bei gefalteten bzw. miteinander gekoppelten Kaskaden können große Spannungsunterschiede zwischen den jeweils endständigen und daher direkt oder nahe benachbarten Elektrodenfingern unterschiedlicher gekoppelter Interdigitalwandler auftreten. Elektrische Überschläge beim Betrieb des Bauelements können vorteilhaft vermieden werden, wenn die direkt benachbarten endständigen Elektrodenfinger jeweils an den Stromschienen befestigt werden, die zueinander den geringsten elektrischen Potentialunterschied aufweisen. In Kaskaden quer zur akustischen Spur ist auch möglich, auf einem mittleren Potential liegende Elektrodenfinger so zu verlängern, daß sie in der benachbarten Spur eine Abschirmung zwischen den endständigen Elektrodenfingern der dort angeordneten gekoppelten und auf extremerem Potential liegenden Interdigitalwandler ausbilden bzw. einen Übergang mit geringerem Potentialunterschied schaffen.

Eine Kaskade kann auch in-line nebeneinander angeordnete Interdigitalwandler umfassen, bei denen ein mittlerer Interdigitalwandler in Serie mit den beiderseits benachbarten äußeren Interdigitalwandlern geschaltet und mit diesen auch akustisch gekoppelt ist. Die äußeren Interdigitalwandler können mit weiteren in-line angeordneten Interdigitalwandlern kaskadiert und gekoppelt sein.

Um in einer Kaskade die gleiche Impedanz wie bei einem unkaskadierten Interdigitalwandler zu erhalten, ist für ein als Filter ausgebildetes Bauelement eine Vergrößerung der Fläche der kaskadierten Interdigitalwandler erforderlich. Bei m kaskadierten Interdigitalwandlern ist eine Gesamtfläche Aₘ in der Kaskade von m²A₀ erforderlich, wobei A₀ der Fläche eines unkaskadierten Interdigitalwandlers entspricht.

In einer Weiterbildung der Erfindung können die beschriebenen einfachen Ausführungen der Erfindung um beliebige weitere Elemente, insbesondere um zusätzliche Interdigitalwandler, erweitert werden. Möglich ist es z.B., im seriellen Arm einen kompletten Eintorresonator, also einen beiderseits von Reflektoren begrenzten Interdigitalwandler zu verschalten. Zusätzliche akustisch nicht gekoppelte Interdigitalwandler im seriellen Arm können, müssen aber nicht, in-line zu den bestehenden seriellen Interdigitalwandlern angeordnet werden.

Jeder Parallelzweig verbindet den seriellen Zweig mit einem Bezugspotential. Dabei ist es möglich, die Zusammenführung mehrerer Parallelzweige auf einer Zwischenstufe vor der endgültigen Verbindung mit dem Bezugspotential (Masse) vorzunehmen. Jeder parallele Zweig kann mehrere Interdigitalwandler aufweisen, die beispielsweise untereinander in Serie geschaltet sind. In einem parallelen Zweig können auch Interdigitalwandler parallel zueinander geschaltet werden. Auch eine beliebige Kaskadierung paralleler Interdigitalwandler ist möglich.

In einer weiteren Ausgestaltung der Erfindung ist ein in einem parallelen Arm angeordneter paralleler Interdigitalwandler Teil eines DMS-Filters. Ein solcher ist beispielsweise aus drei Interdigitalwandlern ausgebildet, die zwischen zwei Reflektoren angeordnet sind. Durch geeignet gewählte Abstände der Interdigitalwandler weist ein solches DMS-Filter zwei Resonanzpole auf. Der parallele Arm ist beispielsweise mit dem mittleren Interdigitalwandler eines DMS-Filters verbunden, welcher in Reihe mit den beiden benachbarten äußeren Interdigitalwandlern geschaltet ist. Die beiden äußeren Interdigitalwandler werden anschließend über die entgegengesetzte Stromschiene mit Bezugspotential bzw. Masse verbunden.

Möglich ist es auch, DMS-Strukturen im seriellen Zweig vorzusehen, wobei zwei oder mehr Interdigitalwandler seriell miteinander verbunden sein können. Die üblicherweise für Masseanbindung vorgesehenen Stromschienen können dabei über einen parallelen Arm mit und ohne parallelen Interdigitalwandler mit dem Bezugspotential verbunden sein.

Die Interdigitalwandler können mit gleicher Fingerperiode auch so um einen Betrag Δx gegeneinander verschoben werden, daß gilt -0,25 < Δx/λ < 0,25, wobei λ die akustische Wellenlänge bei Mittenfrequenz des Bauelements, insbesondere des Filters ist.

Erfindungsgemäße Bauelemente haben von der elektrischen Verschaltung her eine Reaktanzfiltern ähnliche Struktur, arbeiten aber aufgrund der akustischen Verkopplung der Interdigitalwandler anders. Dennoch ist es von Vorteil, die von der Fingerperiode abhängigen Resonanzfrequenzen von seriellen und parallelen Interdigitalwandlern gegeneinander zu verschieben. Jeder Interdigitalwandler weist eine Resonanzfrequenz mit minimaler Impedanz (Nullstelle) und eine Antiresonanzfrequenz mit maximaler Impedanz (Polstelle) auf. Die Antiresonanzfrequenz liegt dabei oberhalb der Resonanzfrequenz. Die Resonanzfrequenz der seriellen Interdigitalwandler wird so gewählt, daß sie ungefähr bei der Antiresonanzfrequenz der parallelen Interdigitalwandler liegt. Die untere Flanke des Durchlaßbereichs (Passband) wird dann von der Lage des Resonanzfrequenz der parallelen Interdigitalwandler, die obere Flanke des Durchlaßbereichs von der Antiresonanz der seriellen Interdigitalwandler bestimmt. Zur Verbreiterung des Durchlaßbereichs ist es möglich, die Resonanzfrequenz der seriellen Interdigitalwandler oberhalb der Antiresonanzfrequenz der parallelen Interdigitalwandler zu wählen. Der Abstand kann maximal so groß gewählt werden, daß noch eine optimale Durchlässigkeit bei noch tolerierbarem Ripple im Durchlaßbereich gewährleistet ist.

Es können in einem Zweig (seriell oder parallel) die Interdigitalwandler um einen geringen Betrag gegeneinander verstimmt werden. Die Verstimmung sollte dabei vorzugsweise maximal 1 % betragen.

Möglich ist es auch, die Interdigitalwandler in beiden Typen von Zweigen gegeneinander zu verstimmen.

Die elektrischen Verbindungen zwischen den Interdigitalwandlern können als normale Leiterbahnen auf dem piezoelektrischen Substrat ausgebildet werden. Möglich ist es jedoch auch, zumindest einen Teil der elektrischen Verbindungen zwischen den Interdigitalwandlern, zwischen den Interdigitalwandlern und Ein- oder Ausgang oder zwischen den Interdigitalwandlern und dem Bezugspotential als diskrete Elemente zu realisieren. Solchen diskreten Elemente können z.B. Kondensatoren, Verzögerungsleitungen, Widerstände, Induktivitäten, Bonddrähte, Bumps oder andere geeignete Verbindungselemente sein.

Erfindungsgemäß können die Interdigitalwandler, die Reflektoren und die sie in der Verschaltung verbindenden leitfähigen Strukturen als metallische Strukturen ausgebildet sein und aus Aluminium, einer Aluminiumlegierung oder Mehrschichtstrukturen bestehen, wobei die Einzelschichten der Mehrschichtstruktur eine oder mehrere Schichten aus Aluminium, einer Aluminiumlegierung oder weiteren Metallen wie Cu, Zr, Mg, Ti oder Sc umfassen. Über den metallischen Strukturen können Passivierungsschichten aus chemisch inerten und insbesondere harten Materialien wie Oxiden, Nitriden, Carbiden und ähnlichen Metallverbindungen vorgesehen sein.

Die Schichtdicken h der metallischen Strukturen werden vorzugsweise im Bereich von 1% < h/λ < 15% ausgewählt.

Eine weitere Variation erfindungsgemäßer Bauelemente besteht darin, die Fingerperiode einzelner Interdigitalwandler über deren Länge gesehen zu variieren. Ebenso kann innerhalb eines Interdigitalwandlers das Metallisierungsverhältnis, also das Verhältnis von Fingerbreite zu Fingerperiode über die Länge des Wandlers variiert werden. Die Variation sowohl des Metallisierungsverhältnisses als auch der Fingerperiode erfolgt vorzugsweise gemäß einer stetigen Funktion, so daß die konkreten Werte für Metallisierungsverhältnis oder Fingerperiode den konkreten Werten einer periodisch abgetasteten stetigen Funktion entsprechen. Eine solche Funktion kann linear sein, so daß die entsprechenden Werte über die Länge des Wandlers ansteigen. Möglich ist es jedoch auch, die Variation gemäß beliebiger anderer Funktionen vorzunehmen. Vorzugsweise erfolgt die Variation gemäß Funktionen, die im Inneren des Wandlers ein Maximum oder ein Minimum aufweisen. Bei der Variation von Fingerperiode und/oder Metallisierungsverhältnis schwankt die jeweilige Größe innerhalb eines Interdigitalwandlers oder Reflektors maximal ca. 3% um den jeweiligen Mittelwert.

Von Vorteil ist auch ein Bauelement, bei dem die Position der transversalen Gaps in einem Typ von Interdigitalwandlern, ausgewählt aus seriellem und parallelem Interdigitalwandlers über die Länge des Interdigitalwandlers gesehen variiert. Unter transversalem Gap wird dabei der Abstand der Enden der Elektrodenfinger in einem Interdigitalwandler von der gegenüberliegenden Stromschiene verstanden. Für die Höhe g der transversalen Gaps kann dabei gelten: g ≤ λ/4.

Auch die Größe der.Gaps kann bei zumindest einem der Interdigitalwandler über die Länge des Interdigitalwandlers gesehen variiert werden.

Unabhängig von Fingerperiode, Fingerabstand, Fingerbreite und Metällisierungsverhältnis in den Interdigitalwandlern und Reflektoren wird in vorteilhafter Weise der Übergang zwischen jeweils zwei innerhalb einer akustischen Spur benachbarten Elementen, ausgewählt aus Interdigitalwandler und Reflektor, quasiperiodisch gestaltet, wie es beispielsweise in der internationalen Anmeldung WO0025423 beschrieben ist, auf die hier vollinhaltlich Bezug genommen wird.

Sowohl bei konstantem als auch bei variierendem Metallisierungsverhältnis ist dieses vorzugsweise größer als 0,5 und besonders bevorzugt größer 0,6.

Für die elektrischen Verbindungen zwischen den Elementen auf dem Substrat, insbesondere zwischen den Interdigitalwandlern gilt, daß sie vorzugsweise zumindest die gleiche Schichtdicke aufweisen wie die Elemente. Vorzugsweise sind diese Verbindungen als Metallflächen und insbesondere mit größerer Schichtdicke ausgebildet als die Interdigitalwandler.

Bei einem erfindungsgemäßen Bauelement kann im seriellen Zweig eine DMS Struktur angeordnet sein, die mit mindestens einem seriellen Interdigitalwandler akustisch gekoppelt ist.

Bei einem erfindungsgemäßen Bauelement können alle seriellen Interdigitalwandler in einer gemeinsamen seriellen Spur und alle parallelen Interdigitalwandler in einer gemeinsamen parallelen Spur angeordnet sein. Dann kann in einfacher Weise die Apertur der parallelen Spur größer gewählt werden als die der seriellen Spur. Vorzugsweise beträgt die Apertur der seriellen Spur zumindest 15λ, wobei λ die akustische Wellenlänge bei Mittenfrequenz des Bauelements ist.

Ein erfindungsgemäßer Interdigitalwandler kann als Normalfingerwandler mit alternierender Anschlußfolge der Elektrodenfinger ausgebildet sein. Möglich ist es jedoch auch, die Anschlußfolge der Elektrodenfinger, also die Folge, mit der die Elektrodenfinger mit den entsprechend gepolten Stromschienen verbunden werden, anders zu gestalten. Werden in einem Wandler Elektrodenfinger im Anschluß vertauscht, also mit der gegenüberliegenden Stromschiene verbunden, so spricht man von Weglaßwichtung. Nicht-alternierende Anschlußfolgen können auch durch rekursive Wandler realisiert sein. In solchen beispielsweise als SPUDT-Wandler ausgebildeten Wandlern können auch die Fingerbreiten unterschiedlich sein, um eine Reflektivität einzustellen, die mit der Phase der Anregung in vorteilhafter Weise zusammenwirkt.

Erfindungsgemäß können auch die Elektrodenfinger der Interdigitalwandler unterschiedlich lang gewählt werden. In einem solchen Fall erhält man eine variierende Überlappung unterschiedlich gepolter Elektrodenfinger, eine Überlappwichtung. Da die jeweilige Überlappung entgegengesetzt gepolter Elektrodenfinger ein Maß für die Anregung akustischer Wellen durch das zwischen den beiden Fingern anliegende Feld ist, kann mit einer solchen Überlappwichtung die Anregung über den Wandler verteilt werden. Dies ist auch mit einer Weglaßwichtung möglich. Weitere Variationsmöglichkeiten der Interdigitalwandler ergeben sich auch durch Positionswichtung, also durch Verschieben von Elektrodenfingern oder Elektrodenfingergruppen, die dann nicht mehr streng an dem durch die Fingerperiode vorgegebenen Raster ausgerichtet sind und dadurch sowohl in der Reflexionswirkung als auch in der Anregungsstärke variiert werden.

Ein erfindungsgemäßes Bauelement mit Reaktanzfilterstruktur kann mit allen oberflächennahen akustischen Wellen arbeiten. Welcher Typ von akustischer Welle bevorzugt angeregt wird, ist insbesondere von Material und Schnittwinkel des gewählten piezoelektrischen Substrats abhängig, welches auch einen piezoelektrischen Film, der auf einem geeigneten Trägersubstrat aufgebracht ist, umfassen kann.

Das piezoelektrische Substrat kann eines der Materialien LiTaO₃, LiNbO₃, Quarz, Langasit (LGS), Langatat (LGT), GaBO₄, Li₂B₄O₇, Langanit (LGN), KNbO₃ oder GaAs umfassen.

Ist das Substrat ein piezoelektrischer Film auf einem Träger, so ist der piezoelektrische- Film vorzugsweise aus einem der Materilaien LiTaO₃, LiNbO₃, AlN, ZnO oder GaAs ausgebildet.

Der Wellentyp kann auch von der Betriebsfrequenz des Bauelements abhängig sein. Als oberflächennahe akustische Wellen sind insbesondere die genannten akustischen Oberflächenwellen (SAW), Rayleigh-Wellen, Scherwellen, Leckwellen, BGS-Wellen (Bleustein Gulyaev Shimizu Wellen) oder HVP-SAW (high velocity pseudo surface acoustic waves) geeignet. Für alle diese Wellentypen sind prinzipiell die gleichen Elektrodenstrukturen bzw. anregenden Interdigitalwandler geeignet.

Im folgenden wird die Erfindung anhand von Ausführungsbeispielen und der dazugehörigen 19 Figuren näher erläutert. Die Figuren sind nur schematisch ausgeführt und daher nicht maßstabsgetreu. Gleiche oder gleichwirkende Teile sind mit gleichen Bezugszeichen bezeichnet.
- Figur 1: zeigt eine Anordnung mit zwei seriellen koppelnden Interdigitalwandlern
- Figur 2: zeigt eine Anordnung mit drei akustisch gekoppelten seriellen Interdigitalwandlern
- Figur 3: zeigt eine Anordnung mit zwei akustisch gekoppelten parallelen Interdigitalwandlern
- Figur 4: zeigt zwei gekoppelte Kaskaden von Interdigitalwandlern
- Figur 5: zeigt drei akustisch gekoppelten Kaskaden von Interdigitalwändlern
- Figur 6: zeigt die Kopplung einer Kaskade mit einem einzelnen Interdigitalwandler
- Figur 7: zeigt die akustische Kopplung von zwei Kaskaden serieller Interdigitalwandler mit einer Kaskade paralleler Interdigitalwandler
- Figur 8: zeigt die Kopplung von in unterschiedlichen Kreisen eines Bauelements angeordneten Interdigitalwandlern
- Figur 9: zeigt eine Ausführung, bei der die Interdigitalwandler zweier unterschiedlicher Kreise akustisch gekoppelt sind
- Figur 10: zeigt die akustische Kopplung zweier Interdigitalwandler mit unterschiedlicher Apertur
- Figur 11: zeigt eine ähnliche Kopplung, wobei die Interdigitalwandler in unterschiedlichen Zweigen eines Bauelements angeordnet sind
- Figur 12: zeigt eine weitere Variation, bei der zwei Kaskaden mit unterschiedlichen Aperturen in unterschiedlichen Zweigen akustisch miteinander gekoppelt sind
- Figur 13: zeigt verschiedene Übergänge akustisch miteinander gekoppelter Interdigitalwandler
- Figur 14: zeigt zwei gekoppelte Interdigitalwandler mit nichtanregenden Elektrodenfingern zwischen den Wandlern
- Figur 15: zeigt zwei akustisch gekoppelte Interdigitalwandler mit einem floatenden Reflektor dazwischen
- Figur 16: zeigt zwei gekoppelte Kaskaden mit floatendem Reflektor zwischen koppelnden Interdigitalwandlern
- Figur 17: zeigt zwei Kaskaden gekoppelter Interdigitalwandler mit einer koppelnden Reflektorstruktur dazwischen
- Figur 18: zeigt zwei Kaskaden akustisch miteinander gekoppelter Interdigitalwandler mit zwei nichtanregenden Elektrodenfingern dazwischen
- Figur 19: zeigt verschiedene Möglichkeiten der Kaskadierung bei insgesamt gleichbleibender Anregung
- Figur 20: zeigt eine Anordnung, bei der jeweils serielle und/oder parallel Interdigitalwandler akustisch gekoppelt sind
- Figur 21: zeigt die gleiche Anordnung, allerdings mit kaskadierten Interdigitalwandlern

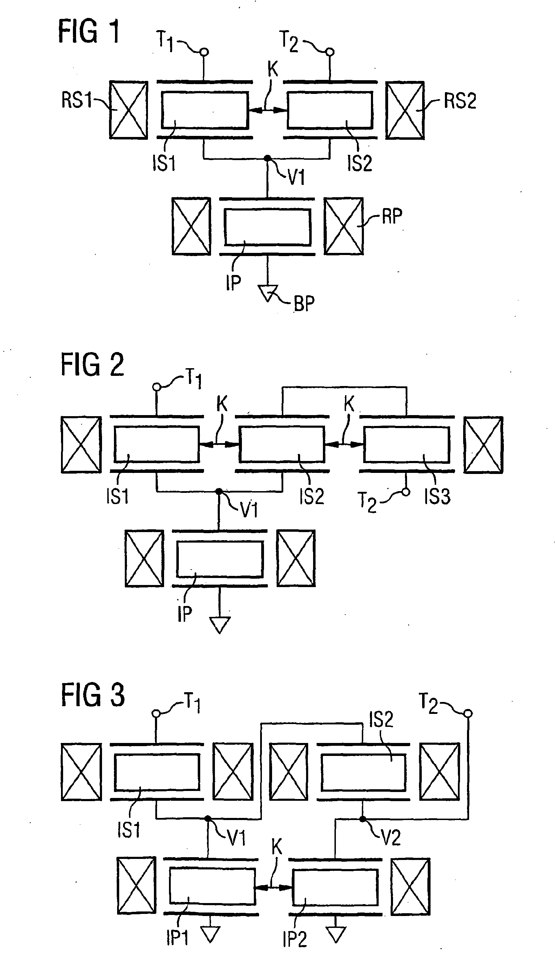

Figur 1 zeigt ein erstes erfindungsgemäßes mit oberflächennahen akustischen Wellen arbeitendes Bauelement, bei dem zwischen einem ersten Anschluß T1 und einem zweiten elektrischen Anschluß T2 ein erster serieller Interdigitalwandler IS1 und ein zweiter serieller Interdigitalwandler IS2 in Serie geschaltet sind. Die beiden Interdigitalwandler sind in Ausbreitungsrichtung in-line hintereinander angeordnet und so nahe beieinander, daß sie akustisch miteinander koppeln können. Die akustische Spur mit den seriellen Interdigitalwandlern IS1, IS2 ist beiderseits von je einem Reflektor RS1, RS2 begrenzt. Zwischen einem Verzweigungspunkt V1, der in der Schaltung zwischen den beiden seriellen Interdigitalwandlern gelegen ist, und einem Bezugspotential BP ist ein beiderseits von je einem Reflektor RP begrenzter paralleler Interdigitalwandler IP angeordnet. Damit ist im parallelen Zweig ein Eintorresonator ausgebildet, während die beiden seriellen Interdigitalwandler mit samt ihren Reflektoren einen Zweitorresonator ausbilden. Im Gegensatz zu bekannten Anordnungen mit akustisch gekoppelten Interdigitalwandlern sind hier die beiden akustisch miteinander koppelnden Interdigitalwandler IS nicht identisch. Sie weisen entweder eine unterschiedliche Apertur, einen unterschiedlichen Pitch (Fingerperiode), eine unterschiedliche Anzahl von Elektrodenfingern, eine unterschiedliche Metallisierungsstärke oder eine unterschiedliche Wichtung auf.

Figur 2 zeigt eine weitere Ausführungsform der Erfindung, die in Abwandlung von Figur 1 einen dritten seriellen Interdigitalwandler IS3 aufweist, der in-line mit den beiden anderen seriellen Interdigitalwandlern IS1 und IS2 angeordnet und mit diesen akustisch gekoppelt ist. Auch hier ist zwischen einer Verzweigungsstelle V1 und dem Bezugspotential ein paralleler Zweig mit einem Interdigitalwandler IP geschaltet. Im Unterschied zu bekannten Anordnungen ist hier die Symmetrie der Abzweigschaltung gestört, die Interdigitalwandler IS2 und IS3 sind seriell kaskadiert, ohne daß zwischen den beiden ein Verzweigungspunkt zur Abzweigung eines parallelen Zweigs vorgesehen ist.

Figur 3 zeigt eine weitere Ausführungsform, bei der in einem seriellen Zweig zwischen einem ersten und einem zweiten Anschluß T1, T2 zwei serielle Interdigitalwandler IS1, IS2 angeordnet sind. Jeder der Interdigitalwandler ist von je zwei Reflektoren begrenzt, so daß keine Kopplung zwischen den beiden Interdigitalwandlern IS auftreten kann. Von einem ersten und einem zweiten Verzweigungspunkt V1, V2 des seriellen Zweigs ist je ein paralleler Zweig gegen ein Bezugspotential geschaltet. In einem ersten parallelen Zweig ist ein paralleler Interdigitalwandler IP1, in einem zweiten parallelen Zweig ein zweiter paralleler Interdigitalwandler IP2 angeordnet. Die beiden parallelen Interdigitalwandler sind akustisch gekoppelt, was in der Figur durch den Doppelpfeil K angedeutet ist. Eine Kopplung kann erfolgen, wenn die beiden parallelen Interdigitalwandler IP zumindest teilweise in der selben akustischen Spur angeordnet sind.

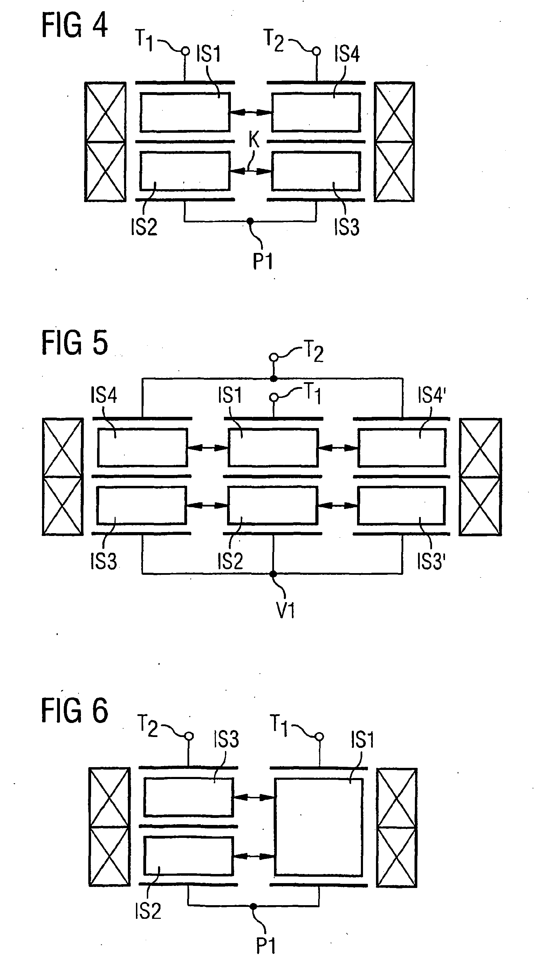

Figur 4 zeigt eine erfindungsgemäße Anordnung, bei der vier Interdigitalwandler IS1 bis IS4 zwischen einem ersten und einem zweiten Anschluß T1, T2 in Serie geschaltet sind. Je zwei der Interdigitalwandler sind kaskadiert, so daß insgesamt eine gefaltete Viererkaskade serieller Interdigitalwandler IS erhalten wird. Die beiden (Teil-)Kaskaden, umfassend die Interdigitalwandler IS1 und IS2 beziehungsweise IS3 und IS4 sind durch die U-förmige Faltung des seriellen Zweigs bzw. allgemein des Zweigs der Verschaltung räumlich so benachbart, daß eine akustische Kopplung zwischen jeweils zwei in unterschiedlichen Kaskaden angeordneten seriellen Interdigitalwandlern auftreten kann, insbesondere eine Kopplung zwischen IS1 und IS4 beziehungsweise zwischen IS2 und IS3. Der serielle Zweig ist am Schaltungspunkt P1 gefaltet, wobei an dieser Stelle ein paralleler Zweig abgezweigt werden kann. Auf beiden Seiten ist die Anordnung von Reflektoren begrenzt, so daß sich zwischen den beiden Reflektoren innerhalb jeder Spur ein Resonanzraum eröffnet.

Figur 5 zeigt eine weitere Anordnung kaskadierter Interdigitalwandler. Zwischen einem ersten Anschluß T1 und einem Verzweigungspunkt V1 sind zwei serielle Interdigitalwandler IS1, IS2 in Serie geschaltet und quer zur Ausbreitungsrichtung der akustischen Welle nebeneinander angeordnet. Zwischen dem Verzweigungspunkt V1 und dem zweiten äußeren Anschluß T2 sind zwei Kaskaden aus je zwei Interdigitalwandlern parallel geschaltet. Eine erste Kaskade umfaßt die Interdigitalwandler IS3 und IS4, die zweite parallel dazu geschaltete Kaskade die Interdigitalwandler IS3' und IS4'. Die Kaskaden sind relativ zueinander so angeordnet, daß in insgesamt zwei akustischen Spuren aus beiden Kaskade je ein Interdigitalwandler angeordnet ist und daß innerhalb einer Spur zwischen den drei dort angeordneten Interdigitalwandlern akustische Kopplung auftritt.

Figur 6 zeigt eine weitere Ausführungsform der Erfindung, bei der ein erster serieller Interdigitalwandler IS1 im seriellen Zweig in Serie mit einer Kaskade aus einem zweiten und einem dritten seriellen Interdigitalwandler IS2, IS3 geschaltet ist. Die Schaltung ist an einem Punkt P1 gefaltet, so daß die Kaskade in-line mit dem ersten Interdigitalwandler IS1 angeordnet ist, dessen Apertur der Summe der Aperturen des zweiten und dritten Interdigitalwandlers IS2, IS3 entspricht. Damit ist der erste Interdigitalwandler IS1 sowohl mit dem zweiten als auch mit dem dritten Interdigitalwandler akustisch gekoppelt. Auf beiden Seiten wird die Anordnung von Reflektoren begrenzt.

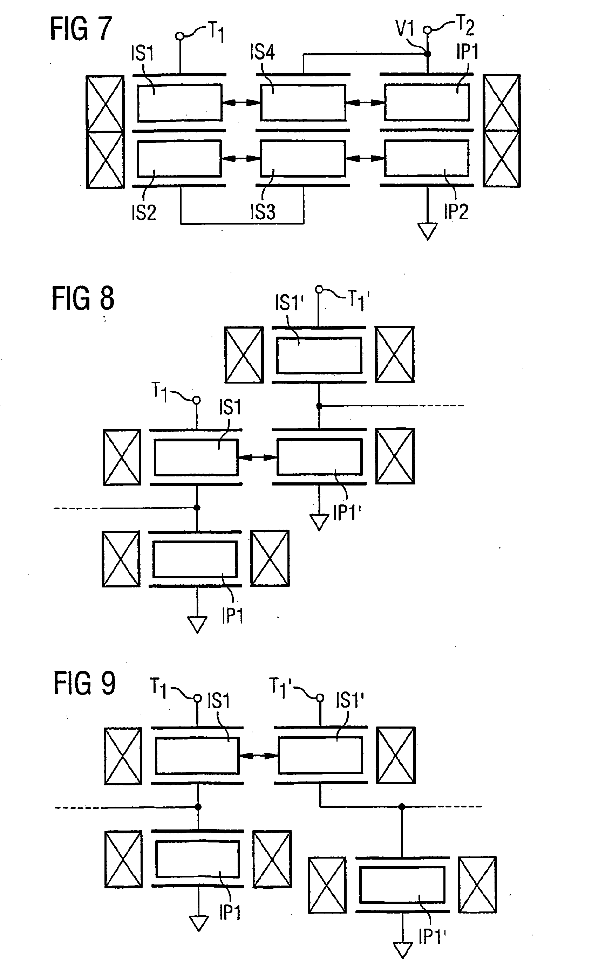

Figur 7 zeigt eine weitere Anordnung, bei der zwischen einem ersten und einem zweiten Anschluß T1, T2 vier serielle Interdigitalwandler IS1 bis IS4 in einer einmal gefalteten Kaskade so angeordnet sind, daß je zwei der Interdigitalwandler miteinander akustisch gekoppelt sind. Von einem nahe dem zweiten Anschluß T2 gelegenen Verzweigungspunkt V1 ist ein paralleler Zweig gegen ein Bezugspotential geschaltet, in dem ein weitere Kaskade aus zwei parallelen Interdigitalwandlern IP2, IP2 angeordnet ist. Die räumliche Anordnung des Parallelzweigs ist so, daß je einer parallelen Interdigitalwandler mit je einem seriellen Interdigitalwandler einer benachbarten seriellen Kaskade akustisch gekoppelt ist.

Figur 8 zeigt eine weitere Ausführungsform der Erfindung, bei der eine akustische Kopplung zwischen Interdigitalwandlern stattfindet, die in voneinander getrennten in Kreisen angeordnet sind. Solche getrennte Kreise, die innerhalb eines Bauelements angeordnet sind, können beispielsweise Interdigitalwandler beziehungsweise Interdigitalwandler umfassende Resonatoren sein, die Teil einer Filterschaltung sind und in einem RX-Zweig oder einem TX-Zweig eines drahtloses Kommunikationsgeräts angeordnet sind. In der Figur ist eine akustische Kopplung zwischen einem seriellen Interdigitalwandler IS1 eines ersten Zweigs und einen parallelen Interdigitalwandler, der im parallelen Zweig eines zweiten Schaltungskreises angeordnet ist. Möglich ist es auch, wie beispielsweise in Figur 9 dargestellt, zwei getrennte Schaltkreise so im Bauelement anzuordnen, daß es zu einer akustischen Kopplung zwischen zwei seriellen Interdigitalwandlern IS1, IS1' kommt, wobei die beiden Interdigitalwandler in den getrennten Schaltkreisen und dort jeweils im seriellen Zweig angeordnet sind Möglich sind auch Anordnungen (in der Figur nicht dargestellt), bei denen in getrennten Schaltkreisen angeordnete Parallelzweige beziehungsweise die darin vorgesehenen parallelen Interdigitalwandler miteinander gekoppelt sind. Die Interdigitalwandler des jeweils anderen Zweigs sind nicht gekoppelt.

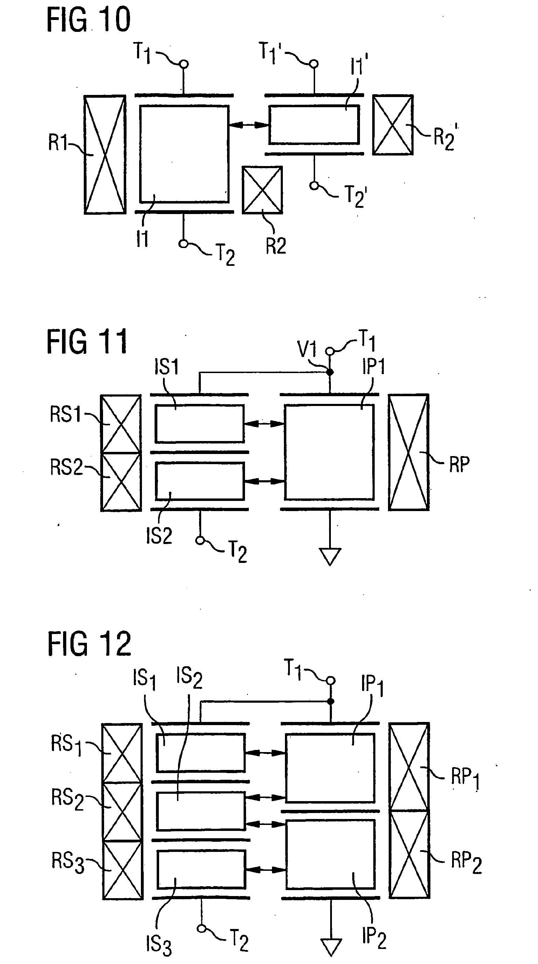

Figur 10 zeigt eine weitere Möglichkeit, zwei voneinander getrennte Kreise, die hier zwischen einem ersten und einem zweiten Anschluß T1 und T2 beziehungsweise zwischen T1' und T2' geschaltet sind, in räumlicher Nähe so zueinander anzuordnen, daß in den Schaltkreisen vorgesehene Interdigitalwandler 11 und 11' (seriell oder parallel) akustisch miteinander koppeln. Durch die unterschiedliche Apertur der beiden koppelnden Interdigitalwandlern erfolgt nur eine teilweise Kopplung, wobei die Spur beziehungsweise die Teilspuren beiderseits von zumindest einem Reflektor begrenzt sind. Kopplungen zwischen Interdigitalwandlern unterschiedlicher Schaltkreise können auch zwischen Interdigitalwandlern erfolgen, die in unterschiedlichen Zweigen, beispielsweise im seriellen und parallelen Zweig angeordnet sind.

Figur 11 zeigt eine Anordnung, bei der in einem seriellen Zweig zwischen ersten und zweiten Anschluß T1, T2 eine Kaskade zweier Interdigitalwandler IS1, IS2 geschaltet ist. Zwischen einem Verzweigungspunkt V1 und dem Bezugspotential ist ein paralleler Interdigitalwandler mit doppelter Apertur so geschaltet, daß er akustisch sowohl mit erstem als auch mit zweitem Interdigitalwandlern IS1, IS2 akustisch koppelt.

Figur 12 zeigt eine ähnliche Ausführung, bei der die Apertur der innerhalb einer Zweierkaskade im parallelen Zweig angeordneten parallelen Interdigitalwandler IP1 und IP2 ein nicht ganzzahliges Vielfaches der Apertur der seriellen Interdigitalwandler aufweist, die als Dreierkaskade im seriellen Zweig angeordnet sind. Serielle und parallele Kaskade sind so nebeneinander angeordnet, daß eine akustische Kopplung zwischen erstem parallelen einerseits und ersten und zweiten seriellen Interdigitalwandler andererseits erfolgt, sowie eine akustische Kopplung zwischen dem zweiten parallelen Interdigitalwandler IP2 einerseits und dem zweiten und dem dritten seriellen Interdigitalwandler andererseits.

Während in den bisherigen Figuren die Interdigitalwandler nur schematisch durch Kästchen angedeutet wurden, die in Wirklichkeit aber von zwei Seiten kammartig ineinander greifende Elektrodenkämme darstellen, die mit unterschiedlichen Stromschienen verbunden sind. Die Anordnung der Elektrodenfinger innerhalb eines solchen Wandlers kann alternierend regelmäßig sein, so daß abwechselnd von je einer Stromschiene ein Finger abgeht und alle Elektrodenfinger gleichmäßig miteinander überlappen. Möglich sind jedoch auch Interdigitalwandler, die eine unregelmäßige Fingerfolge aufweisen oder eine unterschiedliche Überlappungslänge besitzen. Variiert die Überlappungslänge von unterschiedlichen Elektrodenschienen ausgehender Elektrodenfinger, so spricht man von einer Wichtung.

Was die räumliche Anordnung zweier akustisch gekoppelter Interdigitalwandler relativ zueinander betrifft, so muß diese so sein, daß eine akustische Kopplung auftreten kann. Dies ist immer dann der Fall, wenn sich der zweite Interdigitalwandler 12 innerhalb der akustischen Spur des ersten Interdigitalwandlers 11 befindet oder zumindest teilweise innerhalb der akustischen Spur angeordnet ist. Die räumliche Entfernung muß so gering sein, daß im ersten Interdigitalwandler 11 erzeugte akustischen Wellen in den zweiten Wandler gelangen und dort einkoppeln können, ohne daß vorher deren Energie verloren gegangen ist.

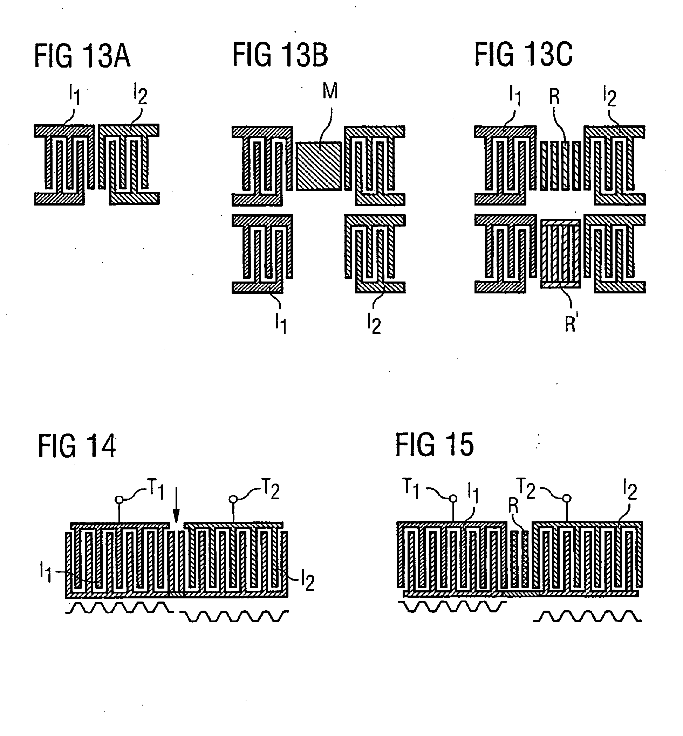

Figur 13 zeigt unterschiedliche Möglichkeiten, zwei akustisch gekoppelte Interdigitalwandler 11, 12 relativ zueinander anzuordnen. In Figur 13a sind die beiden Interdigitalwandler 11, 12 so eng nebeneinander angeordnet, daß die benachbarten jeweils endständigen Elektrodenfinger einen Abstand aufweisen, der dem Abstand der Elektrodenfinger innerhalb jedes der beiden Wandler E1, E2 entspricht. In Abhängigkeit von der Polarität der Stromschienen innerhalb der beiden Interdigitalwandler 11, 12 stellt sich auf diese Weise entweder ein Phasenunterschied von 0 oder 180° ein.

Figur 13b zeigt akustisch gekoppelte Interdigitalwandler 11, 12, deren endständige zueinander weisende Elektrodenfinger um einen Betrag voneinander entfernt sind, der über den Abstand der Elektrodenfinger innerhalb jedes der Wandlers hinaus geht. Zwischen den beiden Wandlern kann die Substratoberfläche dabei unbelegt und frei sein, wie in der Figur 13b unten dargestellt ist. Möglich ist es jedoch auch, die Substratoberfläche zwischen den beiden akustisch gekoppelten Interdigitalwandlern durch eine Metallisierung zu belegen, beispielsweise wie in der Figur 13b, oben dargestellt. Der Abstand zwischen beiden Interdigitalwandler kann beliebig sein, daß jeder gewünschte Phasenunterschied zwischen den beiden Interdigitalwandlern eingestellt werden kann.

Eine weitere Möglichkeit besteht darin, wie in Figur 13c gezeigt, den Abstand zwischen zwei akustisch miteinander gekoppelten Interdigitalwandlern I1, I2 mit reflektierenden Strukturen R oder R' auszufüllen. Die reflektierenden Strukturen können in vorgegebenem Abstand angeordnete Reflektorstreifen sein, wie in Figur 13c oben angedeutet. Möglich ist es jedoch-auch, ein kurzgeschlossenes Reflektorgitter R' zwischen den beiden miteinander koppelnden Interdigitalwandlern vorzusehen. In jedem Fall ist die Reflexionswirkung und daher insbesondere die Anzahl der Reflektorstreifen so bemessen, daß keine vollständige Reflexion auftritt, so daß der Reflektor R, R' für die akustischen Wellen teildurchlässig ist. Über die Reflexionswirkung läßt sich das Ausmaß der akustischen Kopplung zwischen den beiden Interdigitalwandlern einstellen. Die Anzahl der Reflektorstreifen kann zwischen 1 und 100 gewählt werden.

Figur 14 zeigt einen weiteren Aspekt der Erfindung, der die genaue Ausgestaltung am Übergang zwischen zwei akustisch miteinander gekoppelten Interdigitalwandlern betrifft. Je nach Verschaltung und Anordnung der Interdigitalwandler kann zwischen benachbarten Elektrodenfingern unterschiedlicher Interdigitalwandler ein Potentialunterschied auftreten, der wesentlich größer ist als der Potentialunterschied, der zwischen den unterschiedlichen Elektrodenfingern innerhalb eines Wandlers normalerweise auftritt. Zu große Potentialunterschiede können jedoch beim Betrieb eines Interdigitalwandlers, bei dem an einen oder beide der äußeren Anschlüsse ein Hochfrequenzsignal angelegt wird, zu einem elektrischen Überschlag führen, der zumindest den Betrieb des Wandlers beeinträchtigt und oft auch zu einer Beschädigung oder gar Zerstörung des Bauelements führen kann. In erfindungsgemäßer Weiterentwicklung wird der Übergang zwischen akustisch gekoppelten Interdigitalwandlern so gestaltet, daß der Potentialunterschied zwischen benachbarten Elektrodenstrukturen minimiert wird. Figur 14 zeigt eine Anordnung zweier in-line angeordneter seriell miteinander verschalteter und akustisch gekoppelter Interdigitalwandler 11, 12, bei der die endständigen Finger beider Interdigitalwandler an der gleichen Stromschiene befestigt sind, und zwar an der Stromschiene mit mittlerem Potential. Damit herrscht zwischen den beiden endständigen Elektrodenfingern kein Potentialunterschied, zwischen den endständigen und den benachbarten Elektrodenfingern innerhalb eines Wandlers herrscht der normale Potentialunterschied. Unterhalb des Wandler ist in dieser und anderen Figuren der Potentialverlauf beim Betrieb des Wandlers durch entsprechende Sinuskurven angedeutet. Klar ist, daß zwischen den beiden Wandlern an der mit dem Pfeil angedeuteten Stelle kein Potentialunterschied auftritt.

In Figur 15 ist zwischen den beiden akustisch miteinander gekoppelten und elektrisch in Serie geschalteten Interdigitalwandlern 11, I2 ein floatender Reflektor R angeordnet. Auf diese Weise beträgt der Potentialunterschied zwischen den endständigen Elektrodenfingern in den beiden Interdigitalwandlern 11, 12 und dem Reflektor R maximal die Hälfte des Wertes, der zwischen den beiden endständigen Elektrodenfingern unterschiedlicher Interdigitalwandler auftreten kann. Auch so ist die Wahrscheinlichkeit eines elektrischen Überschlags zwischen den Elektrodenstrukturen unterschiedlichen Potentials vermindert.

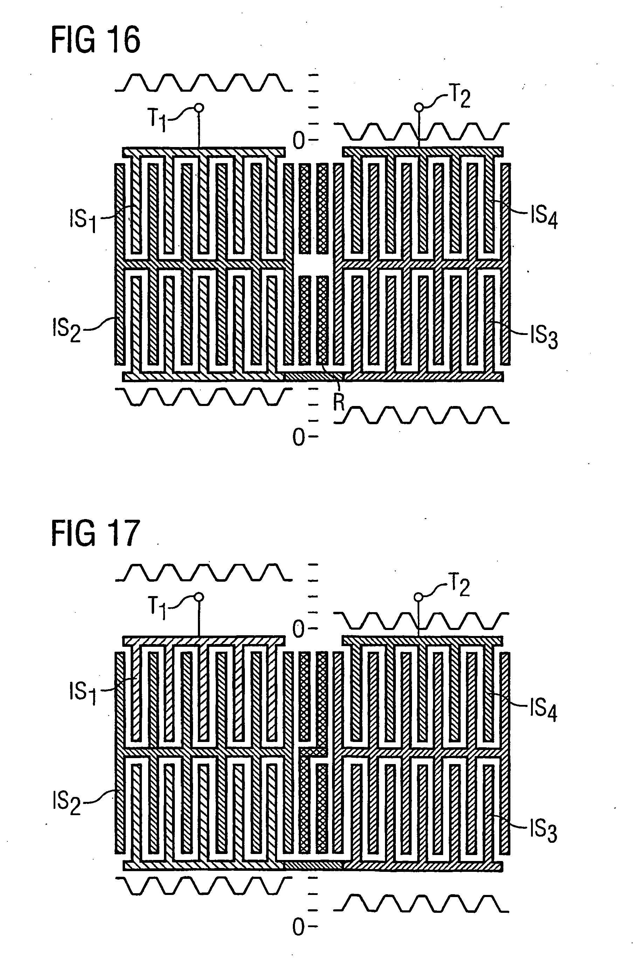

Figur 16 zeigt zwei in Serie geschaltete Kaskaden aus je zwei Interdigitalwandlern, die U-förmig so angeordnet sind, daß jeweils zwei Interdigitalwandler aus unterschiedlichen Kaskaden akustisch miteinander koppeln. Durch die Kaskadierung können an elektrisch nicht miteinander verbundenen Elektrodenstrukturen insgesamt fünf unterschiedliche Potentiale auftreten, die zwischen den extremen Potentialen zu einem hohen Potentialunterschied benachbarter Strukturen führen könnten. Erfindungsgemäß wird dies in der erfindungsgemäßen Ausführung nach Figur 16 verhindert, indem zwischen den beiden Kaskaden pro Spur floatende Reflektorstrukturen R angeordnet sind. Die der Reflektorstruktur benachbarten Elektrodenstrukturen sind außerdem nicht auf maximalem Potential, so daß auch auf diese Weise der Potentialunterschied vermindert wird.

Figur 17 zeigt eine ähnliche Kaskade wie Figur 16 mit dem Unterschied, daß die reflektierenden Strukturen zwischen akustisch miteinander koppelnden und in unterschiedlichen Spuren angeordneten Interdigitalwandlern elektrisch leitend miteinander verbunden sind. Auf diese Weise wird eine kapazitive Kopplung zwischen unterschiedlichen Interdigitalwandlern erzielt, beispielsweise über die elektrische Verbindung zwischen dem unteren Interdigitalwandler der ersten Kaskade und dem in der anderen Spur angeordneten oberen Interdigitalwandler IS4 der zweiten Kaskade.

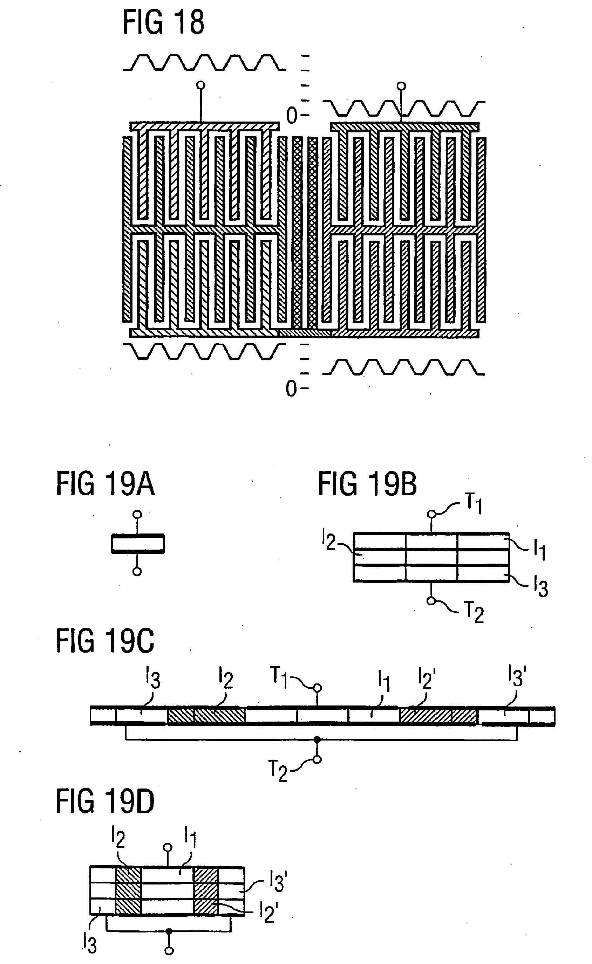

Figur 18 zeigte eine weitere Möglichkeit, den Potentialunterschied innerhalb gefalteter Kaskaden zwischen endständigen Elektrodenstrukturen zu vermindern. Zwei Zweierkaskaden sind über die unterste Stromschiene elektrisch in Serie geschaltet. Dadurch liegt die unterste Stromschiene auf einem mittleren Potential, beispielsweise auf elektrisch neutralem Potential. Zur besseren Abstufung der Potentialunterschiede sind zwei endständige Elektrodenfinger mit der unteren, auf mittlerem Potential liegenden Stromschiene verbunden und so verlängert, daß sie in der unteren Spur als anregende Elektrodenfinger, in der oberen Spur dagegen als gegenphasig anregend wirken können.

Figur 19 zeigt verschiedene Möglichkeiten, wie ein einzelner Interdigitalwandler durch eine Kaskade mehrerer Interdigitalwandler ersetzt werden kann. Da sich durch die Kaskadierung die zwischen den Anschlüssen T1, T2 anliegende Spannung auf die einzelnen kaskadierten Wandler aufteilt, verringert sich im einzelnen Interdigitalwandler die Anregungsstärke. Um den in Figur 19a dargestellten nichtkaskadierten einzelnen Interdigitalwandler einer gegebenen Grundfläche durch eine Dreierkaskade wie in Figur 19b zu ersetzen, ist eine Erhöhung der addierten Grundfläche (Resonatorfläche) aller Interdigitalwandler (Resonatorfläche) um den Faktor n² erforderlich, wobei n die Anzahl der Kaskadenstufen darstellt (in der Figur: n = 3). Eine Dreierkaskade gemäß Figur 19b weist die gleiche Impedanz auf wie der einzelne Interdigitalwandler in Figur 19a, der nur ein Neuntel der Grundfläche benötigt.

Figur 19c zeigt die mögliche Ausführung einer dreifachen Kaskadierung von Interdigitalwandlern, die ebenfalls eine nahezu gleiche Impedanz wie der einzelne Interdigitalwandler in Figur 19a aufweist. Sämtliche kaskadierte Wandler sind in-line innerhalb einer akustischen Spur angeordnet. Ein erster Interdigitalwandler 11 (seriell oder parallel) ist in Serie mit zweiten Interdigitalwandler 12, 12' und dritten Interdigitalwandler 13, 13' geschaltet. Der erste Interdigitalwandler I1 stellt dabei den mittleren Interdigitalwandler dar, so daß die beiden benachbarten äußeren Interdigitalwandler I2 und I2' parallel zueinander aber in Serie zum ersten Interdigitalwandlern I1 geschaltet sind. Ebenso sind die dritten Interdigitalwandler I3, I3' zueinander parallel, jedoch in Serie zu I1. Die erforderliche auf das Neunfache erhöhte Grundfläche dieser kaskadierten Anordnung ist hier bei gleichbleibender Apertur auf eine akustische Spur verteilt. Möglich ist es jedoch auch, die Aperturen innerhalb der Kaskade zu verändern und so in horizontaler und vertikaler Richtung eine Vergrößerung oder Verkleinerung der geometrischen Ausdehnung der Kaskade zu erzielen.

Figur 19d zeigt eine solche Anordnung, die von der Verschaltung her der Anordnung nach Figur 19c entspricht, die jedoch innerhalb der Ausbreitungsrichtung der akustischen Welle eine wesentlich geringere Ausdehnung aufweist.

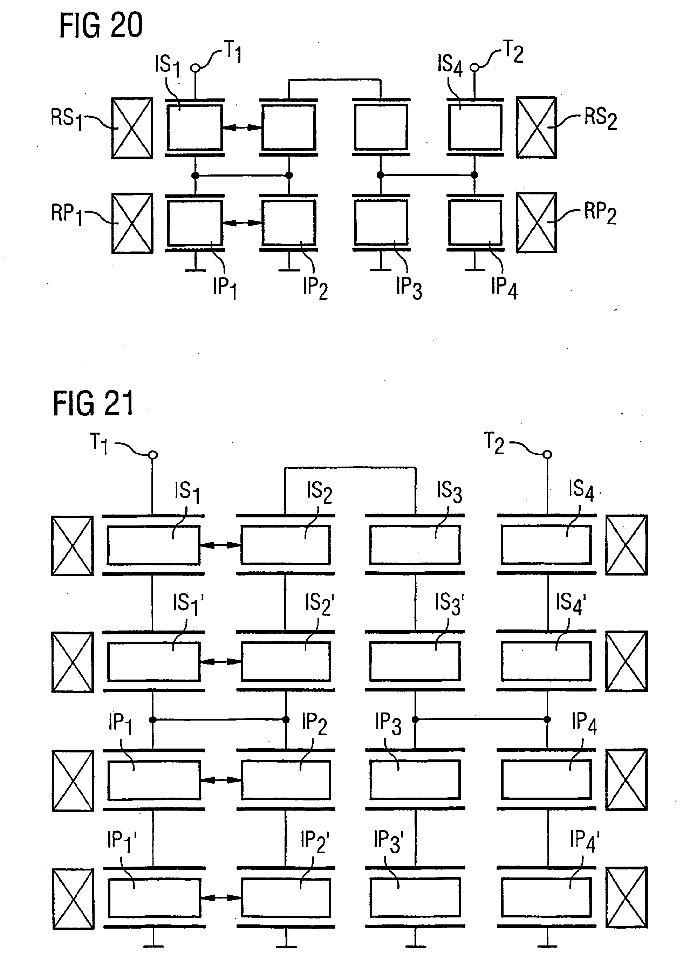

Figur 20 zeigt vier in-line in einem seriellen Zweig zwischen einem ersten und einem zweiten Anschluss verschaltete serielle Interdigitalwandler IS1 bis IS4. Parallel dazu sind vier parallele Zweige mit je einem parallelen Interdigitalwandler IP1,IP2,IP3,IP4 geschaltet. Serielle und parallele Interdigitalwandler sind jeweils in einer gemeinsamen Spur zwischen zwei die Spur begrenzenden Reflektoren RS, RP angeordnet und untereinander akustisch gekoppelt.

Figur 21 zeigt eine dem entsprechende Anordnung, bei der aber jeder der seriellen und parallelen Interdigitalwandler IS, IP durch eine zweifache Kaskade von quer zur Ausbreitungsrichtung der akustischen Welle nebeneinander angeordneten Interdigitalwandlern mit jeweils der doppelten Wandlerfläche ersetzt ist. Die Interdigitalwandler weisen hier die gleiche Apertur wie die in Figur 20 auf. Die gesamte Anordnung weist nun vier akustische Spuren auf, wobei alle Interdigitalwandler innerhalb einer Spur akustisch gekoppelt sind. Die Anordnung besitzt die gleichen Filtereigenschaften wie die in Figur 20 dargestellte, kann diese daher in einem Filter ersetzen, weist aber demgegenüber wegen der vierfachen Wandlerfläche die vierfache Leistungsfestigkeit auf.

In einer Variation sind nur die Interdigitalwandler jeweils eines Typs (seriell IS oder parallel IP) pro Spur miteinander gekoppelt.

Obwohl die Erfindung der Übersichtlichkeit halber nur anhand weniger Ausführungsbeispiele erläutert und dargestellt werden konnte, ist die Erfindung nicht auf die dargestellten Ausführungsbeispiele beschränkt. Variationsmöglichkeiten ergeben sich insbesondere durch Kombination der dargestellten Ausführungsformen und durch Kombination der Verschaltungsanordnungen mit unterschiedlichen Übergängen zwischen akustisch gekoppelten Interdigitalwandlern. Nicht dargestellt wurden insbesondere akustisch gekoppelte Interdigitalwandler mit unterschiedlicher Fingerperiode, unterschiedlichen Metallisierungsverhältnissen, gewichtete Interdigitalwandler, Interdigitalwandler mit variierender Fingerperiode und gekoppelte Interdigitalwandler mit unterschiedlicher Anzahl von Elektrodenfingern sowie verschiedene Varianten von Reflektoren zwischen akustisch gekoppelten Wandlern.

## Patentansprüche

1. Mit oberflächennahen akustischen Wellen arbeitendes Bauelement mit den Merkmalen
auf der Oberfläche eines piezoelektrischen Substrats sind zumindest drei Interdigitalwandler(IS,IP) angeordnet, die jeweils mit einem ersten und einem zweiten elektrischen Anschluß versehen und über diese Anschlüsse elektrisch miteinander verschaltet sind, in mindestens einem als Signalpfad dienenden seriellen Zweig, der den Eingang und den Ausgang des Bauelements verbindet und in dem alle darin enthaltenen Elemente elektrisch in Serie geschaltet sind, ist zumindest ein serieller Interdigitalwandler (IS1, IS2) angeordnet zumindest ein paralleler Zweig, in dem ein paralleler Interdigitalwandler (IP) angeordnet ist, ist parallel dazu gegen ein Bezugspotential geschaltet, zumindest zwei Interdigitalwandler sind in Ausbreitungsrichtung der akustischen Welle hintereinander so angeordnet, daß sie akustisch miteinander gekoppelt sind, wobei die beiden genannten akustisch koppelnden Interdigitalwandler nicht gleichzeitig
a) einen seriellen Interdigitalwandler umfassen,
b) bauartgleich sind und
c) elektrisch direkt miteinander verbunden sind.

2. Bauelement nach Anspruch 1,
bei dem sich die miteinander gekoppelten Interdigitalwandler (IP,IS) unterschiedlich sind und zumindest eines der folgenden Merkmale aufweisen:
a) die Interdigitalwandler weisen unterschiedliche Apertur auf
b) die Interdigitalwandler weisen einen unterschiedlichen Pitch auf
c) die Interdigitalwandler weisen unterschiedliche Anzahl von interdigitalen Elektrodenfingern auf
d) die Interdigitalwandler weisen eine unterschiedliche Metallisierungstärke auf
e) die Interdigitalwandler sind gewichtet und weisen eine unterschiedliche Wichtung auf.

3. Bauelement nach Anspruch 1 oder 2, bei dem von den akustisch gekoppelten Interdigitalwandlern zumindest einer im seriellen Zweig angeordnet ist.

4. Bauelement nach einem der Ansprüche 1 bis 3, bei dem die akustisch gekoppelten Interdigitalwandler unterschiedlichen Zweigen des Bauelements angehören.

5. Bauelement nach einem der Ansprüche 1 bis 3, bei dem die beiden gekoppelten Interdigitalwandler in einem seriellen Zweig angeordnet sind.

6. Bauelement nach einem der Ansprüche 1 bis 5, bei dem zwischen den beiden Interdigitalwandlern eine metallisierte Laufstrecke oder eine Reflektorstruktur angeordnet ist.

7. Bauelement nach einem der Ansprüche 1 bis 5, bei dem die beiden gekoppelten Interdigitalwandler im selben seriellen Zweig angeordnet sind, und bei dem die beiden einander benachbarten endständigen zueinander weisenden Elektrodenfinger der beiden gekoppelten Interdigitalwandler jeweils mit einer so ausgewählten ihrer beiden Stromschienen verbunden sind, dass der Potentialunterschied zwischen den zueinander weisenden Elektrodenfingern minimal ist.

8. Bauelement nach einem der Ansprüche 1 bis 7, bei dem zumindest zwei im seriellen oder parallelen Zweig in der Verschaltung hintereinander folgende, serielle bzw. parallele Interdigitalwandler quer zur
Ausbreitungsrichtung der akustischen Oberflächenwelle nebeneinander angeordnet sind und so eine Kaskade bilden, und bei dem einer dieser Interdigitalwandler akustisch mit einem weiteren Interdigitalwandler gekoppelt ist.

9. Bauelement nach Anspruch 8, bei dem zwei miteinander gekoppelte Interdigitalwandler in ein und derselben Kaskade angeordnet sind.

10. Bauelement nach Anspruch 9, bei dem mehrere Interdigitalwandler einer Kaskade mit einer entsprechenden Anzahl von in einer anderen Kaskade angeordneten weiteren Interdigitalwandlern akustisch gekoppelt sind.

11. Bauelement nach einem der Ansprüche 1 bis 10, bei dem zumindest drei nebeneinander angeordnete serielle Interdigitalwandler Teil einer Kaskade sind, bei dem die drei Interdigitalwandler akustisch gekoppelt sind bei dem die beiden äußeren Interdigitalwandler parallel zueinander und jeweils in Serie zum mittleren Interdigitalwandler verschaltet sind.

12. Bauelement nach einem der Ansprüche 1 bis 11, bei dem zwei serielle Interdigitalwandler miteinander gekoppelt sind, die in der Serienschaltung nicht unmittelbar hintereinander angeordnet sind und zwischen denen in der Verschaltung im seriellen Zweig zumindest ein weiterer akustisch nicht gekoppelter Interdigitalwandler angeordnet ist.

13. Bauelement nach einem der Ansprüche 1 bis 12, bei dem die zwei akustisch gekoppelten Interdigitalwandler (ISl,IS2; IP1,IP2) durch einen akustisch durchlässigen Zwischenreflektor (ZR) voneinander getrennt sind, der eine Anzahl von n Reflektorstreifen aufweist, wobei n eine positive natürliche Zahl ist mit 1≤ n ≤ 100.

14. Bauelement nach einem der Ansprüche 1 bis 13,
- bei dem zumindest zwei serielle Interdigitalwandler (IS1,IS2) vorgesehen und akustisch miteinander gekoppelt sind
- bei dem zumindest zwei parallele Zweige mit je einem parallelen Interdigitalwandler (IP1,IP2) vorgesehen sind, wobei die beiden parallelen Interdigitalwandler akustisch gekoppelt sind.

15. Bauelement nach einem der Ansprüche 1 bis 14, bei dem zwei parallele Interdigitalwandler (IP) vorgesehen sind, die Teil eines DMS Filters sind.

16. Bauelement nach einem der Ansprüche 1 bis 15, bei dem im seriellen Zweig eine DMS Struktur angeordnet ist, die mit mindestens einem seriellen Interdigitalwandler (IS) akustisch gekoppelt ist.

17. Bauelement nach einem der vorangehenden Ansprüche, bei dem alle seriellen Interdigitalwandler (IS) in einer gemeinsamen seriellen Spur (S) und alle parallelen Interdigitalwandler (IP) in einer gemeinsamen parallelen Spur (P) angeordnet sind.

18. Bauelement nach einem der Ansprüche 1 bis 17, bei dem die Apertur der parallelen Spur (P) größer ist als die der seriellen Spur (S).

19. Bauelement nach Anspruch 18, bei dem die Apertur der seriellen Spur (S) zumindest 15λ groß ist, wobei λ die akustische Wellenlänge bei Mittenfrequenz des Bauelements ist.

20. Bauelement nach einem der Ansprüche 1 bis 19, bei dem die zwei akustisch miteinander gekoppelten Interdigitalwandler die gleiche Fingerperiode aufweisen, aber gegeneinander um einen Betrag Δx gegeneinander verschoben sind, mit -0,25 < Δ×/λ < 0,25, wobei λ die akustische Wellenlänge bei Mittenfrequenz des Bauelements ist.

21. Bauelement nach einem der Ansprüche 1 bis 20, bei dem die Fingerperiode der parallelen Interdigitalwandler (IP) größer ist, als die der seriellen Interdigitalwandler (IS) .

22. Bauelement nach einem der Ansprüche 1 bis 21, bei dem seriell zu den seriellen Interdigitalwandlern (IS) weitere Elemente geschaltet sind, ausgewählt aus Eintorresonatoren und DMS Spuren.

23. Bauelement nach einem der Ansprüche 1 bis 22, bei dem seriell zu den parallelen Interdigitalwandlern (IP) weitere Elemente geschaltet sind, ausgewählt aus Eintorresonatoren und DMS Spuren.

24. Bauelement nach einem der Ansprüche 1 bis 23, bei dem zumindest ein Teil der elektrischen Verbindungen zwischen den Interdigitalwandlern (IS, IP) oder zwischen den Interdigitalwandlern und dem Ein- oder Ausgang oder zwischen den Interdigitalwandlern (IS,IP) und der elektrischen Masse als diskrete Elemente realisiert sind, ausgewählt aus Kondensatoren, Verzögerungsleitungen, Widerständen, Induktivitäten, Bonddrähten, Bumps oder anderen geeigneten Elementen.

25. Bauelement nach einem der Ansprüche 1 bis 24, bei dem innerhalb eines Interdigitalwandlers (IP,IS) öder eines Reflektors (RS,RP) die Fingerperiode über die Länge des Interdigitalwandlers oder Reflektors gesehen variiert.

26. Bauelement nach einem der Ansprüche 1 bis 24, bei dem innerhalb eines Interdigitalwandlers (IP,IS) oder eines Reflektors (RS,RP) das Metallisierungsverhältnis über die Länge des Interdigitalwandlers oder Reflektors gesehen variiert.

27. Bauelement nach einem der Ansprüche 25 oder 26, bei dem die konkreten Werte für Metallisierungsverhältnis oder Fingerperiode maximal +/- 3% um einen mittleren Wert schwanken.

28. Bauelement nach einem der Ansprüche 25 bis 27, bei dem die konkreten Werte für Metallisierungsverhältnis oder Fingerperiode über die Länge des Interdigitalwandlers (IP,IS) oder eines Reflektors (RS,RP) gesehen den konkreten Werten einer periodisch abgetasteten stetigen Funktion entsprechen.

29. Bauelement nach einem der Ansprüche 1 bis 28, bei dem zwischen zwei innerhalb einer akustischen Spur benachbarten Elementen, ausgewählt aus Interdigitalwandler und Reflektor, eine Phasenverschiebung besteht oder eine unterschiedliche Fingerperiode eingestellt ist, wobei der Übergang zwischen den beiden Elementen quasiperiodisch ist.

30. Bauelement nach einem der Ansprüche 1 bis 29, bei dem die Anschlußfolge der Elektrodenfinger an einem Interdigitalwandler (IP,IS) nicht regelmäßig alternierend ist und der Interdigitalwandler eine Weglasswichtung aufweist.

31. Bauelement nach einem der Ansprüche 1 bis 30, bei dem die Position der transversalen Gaps in einem Typ von Interdigitalwandlern (IP,IS) über die Länge des Interdigitalwandlers gesehen variiert.

32. Bauelement nach einem der vorangehenden Ansprüche, bei dem die Größe der transversalen Gaps in einem Typ von Interdigitalwandlern (IP,IS) über die Länge des Interdigitalwandlers gesehen variiert.

33. Bauelement nach einem der Ansprüche 31 oder 32, bei dem für die Höhe g der transversalen Gaps gilt: g ≤ λ/4.

34. Bauelement nach einem der Ansprüche 1 bis 33, bei dem die Interdigitalwandler (IP,IS) jeweils Resonatoren angehören, die jeweils eine Resonanzfrequenz und eine Antiresonanzfrequenz aufweisen, wobei die Resonanzfrequenz der seriellen Interdigitalwandler (IS) im Bereich der Antiresonanzfrequenz der parallelen Interdigitalwandler (IP) oder wenig darüber liegt.

35. Bauelement nach einem der Ansprüche 1 bis 34, bei dem die seriellen Interdigitalwandler (IS) gegeneinander verstimmt sind.

36. Bauelement nach einem der Ansprüche 1 bis 35, bei dem innerhalb einer akustischen Spur alle Aperturen oder Überlappungen der Elektrodenfinger gleich sind.

37. Bauelement nach einem der Ansprüche 1 bis 36, bei dem die parallelen Interdigitalwandler (IP) gegeneinander verstimmt sind.

38. Bauelement nach einem der vorangehenden Ansprüche, mit einem piezoelektrischen Substrat, das eine durch geeigneten Schnittwinkel an Kristallachsen ausgerichtete Oberfläche aufweist, die für niedrige Verluste bei Oberflächenwellen, Raleighwellen, Scherwellen, Leckwellen, BGS-Wellen oder HVPSAW bekannt ist.

39. Bauelement nach einem der Ansprüche 1 bis 38, bei dem das piezoelektrische Substrat eines der Materialien LiTaO₃, LiNbO₃, Quarz, Langasit, Langatat, GaBO₄, Li2B₄O₇, Langanit, KNbO₃ oder GaAs umfaßt.

40. Bauelement nach einem der vorangehenden Ansprüche, bei dem das piezoelektrische Substrat einen piezoelektrischen Film umfaßt, der auf einem Trägersubstrat aufgebracht ist.

41. Bauelement nach Anspruch 40, bei dem der piezoelektrische Film LiTaO₃, LiNbO₃, AlN, ZnO oder GaAs umfaßt.

42. Bauelement nach einem der vorangehenden Ansprüche, bei dem die Interdigitalwandler (IP,IS), die Reflektoren (RS,RP) und die sie in der Verschaltung verbindenden leitfähigen Strukturen als metallische Strukturen ausgebildet sind und aus Aluminium, einer Aluminiumlegierung oder Mehrschichtstrukturen bestehen, wobei die Einzelschichten der Mehrschichtstruktur eine oder mehrere Schichten aus Aluminium, einer Aluminiumlegierung oder weiteren Metallen wie Cu, Zr, Mg, Ti oder Sc umfassen.

43. Bauelement nach Anspruch 42, bei dem die Schichtdicken h der metallischen Strukturen im Bereich von 1% < h/λ < 15% ausgewählt sind.

44. Bauelement nach Anspruch 42 oder 43, bei dem über den metallischen Strukturen Passivierungsschichten vorgesehen sind.

45. Bauelement nach einem der Ansprüche 1 bis 44,
bei dem das Bezugspotential, gegen das der zumindest eine parallele Zweig geschaltet ist, ein frei floatendes inneres Bezugspotential ist.

## Claims

1. Component operating with near-surface acoustic waves, comprising the following features:
- at least three interdigital transducers (IS, IP) are arranged on the surface of a piezoelectric substrate, which transducers are in each case provided with a first and a second electrical connection and are electrically interconnected with one another via said connections,
- at least one serial interdigital transducer (IS1, IS2) is arranged in at least one serial branch which serves as a signal path and which connects the input and the output of the component and in which all of the elements contained therein are electrically connected in series,
- at least one parallel branch in which a parallel interdigital transducer (IP) is arranged is connected in parallel therewith relative to a reference potential,
- at least two interdigital transducers are arranged one behind another in a propagation direction of the acoustic wave in such a way that they are acoustically coupled to one another, wherein the two acoustically coupling interdigital transducers mentioned are embodied so as to not simultaneously
a) comprise a serial interdigital transducer,
b) be of identical structural type and
c) be electrically connected directly to one another.

2. Component according to Claim 1,
wherein the interdigital transducers (IP, IS) coupled to one another are different and have at least one of the following features:
a) the interdigital transducers have a different aperture
b) the interdigital transducers have a different pitch
c) the interdigital transducers have a different number of interdigital electrode fingers
d) the interdigital transducers have a different metallization thickness
e) the interdigital transducers are weighted and have a different weighting.

3. Component according to Claim 1 or 2,
wherein at least one of the acoustically coupled interdigital transducers is arranged in the serial branch.

4. Component according to any of Claims 1 to 3,
wherein the acoustically coupled interdigital transducers belong to different branches of the component.

5. Component according to any of Claims 1 to 3,
wherein the two coupled interdigital transducers are arranged in a serial branch.

6. Component according to any of Claims 1 to 5,
wherein a metallized pathway or a reflector structure is arranged between the two interdigital transducers.

7. Component according to any of Claims 1 to 5,
wherein the two coupled interdigital transducers are arranged in the same serial branch, and
wherein the two mutually adjacent end-positioned electrode fingers - facing one another - of the two coupled interdigital transducers are respectively connected to one of their two busbars which is selected such that the potential difference between the electrode fingers facing one another is minimal.

8. Component according to any of Claims 1 to 7,
wherein at least two serial or parallel interdigital transducers which follow one behind another in the serial or parallel branch in the interconnection are arranged alongside one another transversely with respect to the propagation direction of the surface acoustic wave and thus form a cascade, and wherein one of said interdigital transducers is acoustically coupled to a further interdigital transducer.

9. Component according to Claim 8,
wherein two interdigital transducers coupled to one another are arranged in one and the same cascade.

10. Component according to Claim 9,
wherein a plurality of interdigital transducers of one cascade are acoustically coupled to a corresponding number of further interdigital transducers arranged in another cascade.

11. Component according to any of Claims 1 to 10,
wherein at least three serial interdigital transducers arranged alongside one another are part of a cascade,
wherein the three interdigital transducers are acoustically coupled,
wherein the two outer interdigital transducers are interconnected in parallel with one another and in each case in series with the middle interdigital transducer.

12. Component according to any of Claims 1 to 11,
wherein two serial interdigital transducers are coupled to one another which are not arranged directly one behind another in the series connection and between which at least one further interdigital transducer which is not acoustically coupled is arranged in the interconnection in the serial branch.

13. Component according to any of Claims 1 to 12,
wherein the two acoustically coupled interdigital transducers (IS1, IS2; IP1, IP2) are separated from one another by an acoustically transmissive intermediate reflector (ZR) having a number of n reflector strips, where n is a positive natural number where 1 ≤ n ≤ 100.

14. Component according to any of Claims 1 to 13,
- wherein at least two serial interdigital transducers (IS1, IS2) are provided and acoustically coupled to one another,
- wherein at least two parallel branches each having a parallel interdigital transducer (IP1, IP2) are provided, the two parallel interdigital transducers being acoustically coupled.

15. Component according to any of Claims 1 to 14,
wherein two parallel interdigital transducers (IP) are provided which are part of a DMS filter.

16. Component according to any of Claims 1 to 15,
wherein a DMS structure is arranged in the serial branch, said DMS structure being acoustically coupled to at least one serial interdigital transducer (IS).

17. Component according to any of the preceding claims,
wherein all of the serial interdigital transducers (IS) are arranged in a common serial track (S) and all of the parallel interdigital transducers (IP) are arranged in a common parallel track (P).

18. Component according to any of Claims 1 to 17,
wherein the aperture of the parallel track (P) is greater than that of the serial track (S).

19. Component according to Claim 18,
wherein the aperture of the serial track (S) has a magnitude of at least 15 λ, where λ is the acoustic wavelength at the centre frequency of the component.

20. Component according to any of Claims 1 to 19,
wherein the two interdigital transducers which are acoustically coupled to one another have the same finger period, but are shifted by a magnitude Δx relative to one another, where -0.25 < Δx/λ. < 0.25, where λ is the acoustic wavelength at the centre frequency of the component.

21. Component according to any of Claims 1 to 20,
wherein the finger period of the parallel interdigital transducers (IP) is greater than that of the serial interdigital transducers (IS).

22. Component according to any of Claims 1 to 21,
wherein further elements, selected from single-port resonators and DMS tracks, are connected in series with the serial interdigital transducers (IS).

23. Component according to any of Claims 1 to 22,
wherein further elements, selected from single-port resonators and DMS tracks, are connected in series with the parallel interdigital transducers (IP).

24. Component according to any of Claims 1 to 23,
wherein at least some of the electrical connections between the interdigital transducers (IS, IP) or between the interdigital transducers and the input or output or between the interdigital transducers (IS, IP) and the electrical earth are realized as discrete elements, selected from capacitors, delay lines, resistors, inductances, bonding wires, bumps or other suitable elements.

25. Component according to any of Claims 1 to 24,
wherein, within an interdigital transducer (IP, IS) or a reflector (RS, RP), the finger period varies as seen over the length of the interdigital transducer or reflector.

26. Component according to any of Claims 1 to 24,
wherein, within an interdigital transducer (IP, IS) or a reflector (RS, RP), the metallization ratio varies as seen over the length of the interdigital transducer or reflector.

27. Component according to either of Claims 25 and 26,
wherein the concrete values for metallization ratio or finger period fluctuate at most +/- 3% around an average value.

28. Component according to any of Claims 25 to 27,
wherein the concrete values for metallization ratio or finger period, as seen over the length of the interdigital transducer (IP, IS) or a reflector (RS, RP), correspond to the concrete values of a periodically sampled continuous function.

29. Component according to any of Claims 1 to 28,
wherein, between two elements adjacent within an acoustic track, selected from interdigital transducer and reflector, there is a phase shift or a different finger period is set, the transition between the two elements being quasiperiodic.

30. Component according to any of Claims 1 to 29,
wherein the connection sequence of the electrode fingers at an interdigital transducer (IP, IS) is not regularly alternating and the interdigital transducer has an omission weighting.

31. Component according to any of Claims 1 to 30,
wherein the position of the transverse gaps in one type of interdigital transducers (IP, IS) varies as seen over the length of the interdigital transducer.

32. Component according to any of the preceding claims,
wherein the size of the transverse gaps in one type of interdigital transducers (IP, IS) varies as seen over the length of the interdigital transducer.

33. Component according to either of Claims 31 or 32,
wherein the following holds true for the height g of the transverse gaps: g ≤ λ/4.

34. Component according to any of Claims 1 to 33,
wherein the interdigital transducers (IP, IS) respectively belong to resonators which respectively have a resonant frequency and an antiresonant frequency, the resonant frequency of the serial interdigital transducers (IS) lying in the range of the antiresonant frequency of the parallel interdigital transducers (IP) or a little above that.

35. Component according to any of Claims 1 to 34,
wherein the serial interdigital transducers (IS) are detuned relative to one another.

36. Component according to any of Claims 1 to 35,
wherein all apertures or overlaps of the electrode fingers are identical within an acoustic track.

37. Component according to any of Claims 1 to 36,
wherein the parallel interdigital transducers (IP) are detuned relative to one another.

38. Component according to any of the preceding claims,
comprising a piezoelectric substrate having a surface which is oriented by a suitable cut angle at crystal axes and which is known for low losses in the case of surface waves, Raleigh waves, shear waves, leaky waves, BGS waves or HVPSAW.

39. Component according to any of Claims 1 to 38,
wherein the piezoelectric substrate comprises one of the materials LiTaO₃, LiNbO₃, quartz, langasite, langatate, GaBO₄, Li₂B₄O₇, langanite, KNbO₃ or GaAs.

40. Component according to any of the preceding claims,
wherein the piezoelectric substrate comprises a piezoelectric film applied on a carrier substrate.

41. Component according to Claim 40,
wherein the piezoelectric film comprises LiTaO₃, LiNbO₃, AlN, ZnO or GaAs.

42. Component according to any of the preceding claims,
wherein the interdigital transducers (IP, IS), the reflectors (RS, RP) and the conductive structures which connect them in the interconnection are formed as metallic structures and consist of aluminium, an aluminium alloy or multilayer structures, the individual layers of the multilayer structure comprising one or a plurality of layers composed of aluminium, an aluminium alloy or further metals such as Cu, Zr, Mg, Ti or Sc.

43. Component according to Claim 42,
wherein the layer thicknesses h of the metallic structures are selected within the range of 1% < h/λ < 15%.

44. Component according to Claim 42 or 43,
wherein passivation layers are provided over the metallic structures.

45. Component according to any of Claims 1 to 44,
wherein the reference potential relative to which the at least one parallel branch is connected is a freely floating internal reference potential.

## Revendications

1. Composant fonctionnant avec des ondes acoustiques proches de la surface et ayant les caractéristiques
- sur la surface d'un substrat piézoélectrique sont disposés au moins trois convertisseurs ( IS, IP ) interdigités, qui sont munis respectivement d'une première et d'une deuxième borne électrique et qui sont câblés entre eux électriquement par ces bornes,
- dans au moins une branche série, servant de trajet du signal reliant l'entrée et la sortie du composant et dans laquelle tous les éléments qui y sont contenus sont montés électriquement en série, est monté au moins un convertisseur ( IS1, IS2) interdigité série,
- au moins une branche parallèle dans laquelle est monté un convertisseur ( IP ) interdigité parallèle est montée en parallèle à cela par rapport à un potentiel de référence,
- au moins deux convertisseurs interdigités sont disposés l'un derrière l'autre dans la direction de propagation des ondes acoustiques de manière à être couplés acoustiquement entre eux en n'ayant pas en même temps pour les deux convertisseurs interdigités mentionnés couplés acoustiquement
a ) ils comprennent un convertisseur interdigité série,
b ) ils soient du même type de construction,
c ) ils soient reliés électriquement directement entre eux.

2. Composant suivant la revendication 1,
dans lequel les convertisseurs ( IP, IS ) interdigités couplés entre eux sont différents et ont au moins l'une des caractéristiques suivantes .
a ) les convertisseurs interdigités ont des ouvertures différentes
b ) les convertisseurs interdigités ont un pas différent
c ) les convertisseurs interdigités ont des nombres différents de doigts d'électrodes interdigitées
d ) les convertisseurs interdigités ont une épaisseur de métallisation différente
e ) les convertisseurs interdigités sont pondérés et ont une pondération différente.

3. Composant suivant la revendication 1 ou 2,
dans lequel parmi les convertisseurs interdigités couplés acoustiquement au moins l'un est monté dans la branche série.

4. Composant suivant l'une des revendications 1 à 3,
dans lequel les convertisseurs interdigités couplés acoustiquement appartiennent à des branches différentes du composant.

5. Composant suivant l'une des revendications 1 à 3,
dans lequel les deux convertisseurs interdigités couplés sont disposés dans une branche série.

6. Composant suivant l'une des revendications 1 à 5,
dans lequel une section de passage métallisée ou une structure de réflecteur est disposée entre les deux convertisseurs interdigités.

7. Composant suivant l'une des revendications 1 à 5,
dans lequel les deux convertisseurs interdigités couplés sont disposés dans la même branche série et dans lequel les deux doigts d'électrodes voisins l'un de l'autre en position d'extrémité et tournés l'un vers l'autre des deux convertisseurs interdigités couplés sont reliés respectivement à l'une de leurs deux barres de courant sélectionnée de façon à ce que la différence de potentiel entre les doigts d'électrodes tournés l'un vers l'autre soit minimum.

8. Composant suivant l'une des revendications 1 à 7,
dans lequel deux convertisseurs interdigités série ou parallèles se succédant dans la branche série ou parallèle dans le câblage, l'un derrière l'autre, sont disposés côte à côte transversalement par rapport à la direction de propagation des ondes de surface acoustiques et forment ainsi une cascade et dans lequel l'un de ces convertisseurs interdigités est couplé acoustiquement à un autre convertisseur interdigité.

9. Composant suivant la revendication 8,
dans lequel deux convertisseurs interdigités couplés entre eux sont montés dans une seule et même cascade.

10. Composant suivant la revendication 9,
dans lequel plusieurs convertisseurs interdigités d'une cascade sont couplés acoustiquement à un nombre correspondant d'autres convertisseurs interdigités montés dans une autre cascade.

11. Composant suivant l'une des revendications 1 à 10,
dans lequel au moins trois convertisseurs interdigités série disposés l'un à côté de l'autre font partie d'une cascade,
dans lequel les trois convertisseurs interdigités sont couplés acoustiquement,
dans lequel les deux convertisseurs interdigités extérieurs sont montés en parallèle l'un avec l'autre et respectivement en série avec le convertisseur interdigité médian.

12. Composant suivant l'une des revendications 1 à 11,
dans lequel deux convertisseur interdigités série sont couplés entre eux, sont disposés dans le circuit série non directement l'un derrière l'autre et, entre eux, est monté dans le montage dans la branche série au moins un autre convertisseur interdigité non couplé acoustiquement.

13. Composant suivant l'une des revendications 1 à 12,
dans lequel les deux convertisseurs ( IS1, IS2 ; IP1, IP2 ) interdigités couplés acoustiquement sont séparés l'un de l'autre par un réflecteur ( ZR ) intermédiaire perméable acoustiquement, qui a un nombre de n bandes de réflecteur, n étant un entier naturel positif avec 1 ≤ n ≤ 100.

14. Composant suivant l'une des revendications 1 à 13,
- dans lequel au moins deux convertisseurs ( IS1, IS2 ) interdigités série sont prévus et sont couplés acoustiquement entre eux
- dans lequel au moins deux branches parallèles ayant chacune un convertisseur ( IP1, IP2 ) interdigités parallèles sont prévues, les deux convertisseurs interdigités parallèles étant couplés acoustiquement.

15. Composant suivant l'une des revendications 1 à 14,
dans lequel il est prévu deux convertisseurs ( IP) interdigités parallèles qui font partie d'un filtre DMS.

16. Composant suivant l'une des revendications 1 à 15,
dans lequel il est monté dans la branche série une structure DMS qui est couplée acoustiquement à au moins un convertisseur ( IS ) interdigité série.

17. Composant suivant l'une des revendications précédentes,
dans lequel tous les convertisseurs ( IS ) interdigités série sont montés dans une piste ( S ) série commune et tous les convertisseurs ( IP ) interdigités parallèles dans une piste ( P ) parallèle commune.

18. Composant suivant l'une des revendications 1 à 17,
dans lequel l'ouverture de la piste ( P) parallèle est plus grande de celle de la piste ( S ) série.

19. Composant suivant la revendication 18,
dans lequel l'ouverture de la piste ( S ) série est d'au moins 15 λ, λ étant la longueur d'onde acoustique à la fréquence médiane du composant.

20. Composant suivant l'une des revendications 1 à 19,
dans lequel les deux convertisseurs interdigités couplés entre eux acoustiquement ont la même période de doigt, mais sont décalés l'un par rapport à l'autre d'un montant Δx avec -0,25 < Δx/λ < 0,25, λ étant la longueur d'onde acoustique à la fréquence médiane du composant.

21. Composant suivant l'une des revendications 1 à 20,
dans lequel la période de doigt des convertisseurs ( IP ) interdigités parallèles est plus grande que celle des convertisseurs ( IS ) interdigités série.

22. Composant suivant l'une des revendications 1 à 21,
dans lequel d'autres éléments, choisis parmi des résonateurs à une porte et des pistes DMS, sont montés en série avec des convertisseurs ( IS ) interdigités série.

23. Composant suivant l'une des revendications 1 à 22,
dans lequel d'autres éléments, choisis parmi des résonateurs à une porte et des pistes DMS, sont montés en série avec les convertisseurs ( IP ) interdigités parallèles.

24. Composant suivant l'une des revendications 1 à 23,
dans lequel au moins une partie des liaison électriques entre les convertisseurs ( IS, IP ) interdigités ou entre les convertisseurs interdigités et l'entrée ou la sortie ou entre les convertisseurs ( IS, IP ) interdigités et la masse électrique sont réalisées sous la forme d'éléments discrets choisis parmi des condensateurs, des lignes de temporisation, des résistances, des inductances, des fils de liaison, des bossages ou d'autres éléments appropriés.

25. Composant suivant l'une des revendications 1 à 24,
dans lequel, à l'intérieur d'un convertisseur ( IP, IS ) interdigité ou d'un réflecteur ( RS, RP ), la période de doigt varie, considérée sur la longueur du convertisseur interdigité ou du réflecteur.

26. Composant suivant l'une des revendications 1 à 24,
dans lequel, à l'intérieur d'un convertisseur ( IP, IS ) interdigité ou d'un réflecteur ( RS, RP ), le rapport de métallisation varie, considéré sur la longueur du convertisseur interdigité ou du réflecteur.

27. Composant suivant l'une des revendications 25 ou 26,
dans lequel les valeurs concrètes du rapport de métallisation ou de la période de doigt fluctuent au maximum de +/- 3 % autour d'une valeur moyenne.

28. Composant suivant l'une des revendications 25 à 27,
dans lequel les valeurs concrètes du rapport de métallisation ou de la période de doigt, considéré sur la longueur du convertisseur ( IP, IS ) interdigité ou d'un réflecteur ( RS, RP ), correspondent aux valeurs concrètes d'une fonction continue échantillonnée périodiquement.

29. Composant suivant l'une des revendications 1 à 28,
dans lequel il y a entre deux éléments voisins à l'intérieur d'une piste acoustique, choisis parmi un convertisseur interdigité et un réflecteur, un décalage de phase ou il est établi une période différente de doigt, la transition entre les deux éléments étant quasi périodique.

30. Composant suivant l'une des revendications 1 à 29,
dans lequel la succession de bornes des doigts d'électrodes sur un convertisseur ( IP, IS) interdigité alterne d'une manière non régulière et le convertisseur interdigité a une pondération qui n'est pas utilisée.

31. Composant suivant l'une des revendications 1 à 30,
dans lequel la position des intervalles transversaux dans un type de convertisseurs ( IP, IS ) interdigités varie, considérée sur la longueur du convertisseur interdigité.

32. Composant suivant l'une des revendications précédentes,
dans lequel la dimension des intervalles transversaux dans un type de convertisseurs ( IP, IS ) interdigités varie, considérée sur la longueur du convertisseur interdigité.

33. Composant suivant l'une des revendications 31 ou 32,
dans lequel pour la hauteur g des intervalles transversaux on a : g ≤ λ/4.

34. Composant suivant l'une des revendications 1 à 33,
dans lequel les convertisseurs ( IP, IS) interdigités appartiennent, respectivement, à des résonateurs qui ont respectivement une fréquence de résonance et une fréquence d'antirésonance, la fréquence de résonance des convertisseurs ( IS ) interdigités série étant dans la plage de la fréquence d'antirésonance des convertisseurs ( IP ) interdigités parallèles ou un peu supérieure.

35. Composant suivant l'une des revendications 1 à 34,
dans lequel les convertisseurs ( IS ) interdigités série sont désaccordés les uns par rapport aux autres.

36. Composant suivant l'une des revendications 1 à 35,
dans lequel, à l'intérieur d'une piste acoustique, toutes les ouvertures ou les chevauchements des doigts d'électrodes sont les mêmes.

37. Composant suivant l'une des revendications 1 à 36,
dans lequel les convertisseurs ( IP ) interdigités parallèles sont désaccordés les uns par rapport aux autres.

38. Composant suivant l'une des revendications précédentes,
comprenant un substrat piézoélectrique qui a une surface orientée sur des axes cristallins par un angle de coupe approprié qui est connu pour de petites pertes dans des ondes de surface, des ondes de Raleigh, des ondes de cisaillement, des ondes de fuite, des ondes BGS ou des HVPSAW.

39. Composant suivant l'une des revendications 1 à 38,
dans lequel le substrat piézoélectrique comprend l'un des matériaux LiTaO₃, LiNbO₃, quartz, langasite, langatate, GaBO₄, Li₂B₄O₇, langanite, KNbO₃ ou GaAs.

40. Composant suivant l'une des revendications précédentes,
dans lequel le substrat piézoélectrique comprend un film piézoélectrique qui est déposé sur un substrat de support.

41. Composant suivant la revendication 40,
dans lequel le film piézoélectrique comprend LiTaO₃, LiNbO₃, AlN, ZnO ou GaAs.

42. Composant suivant l'une des revendications précédentes,
dans lequel le convertisseur ( IP, IS) interdigité, les réflecteurs ( RS, RP ) et les structures conductrices les reliant dans le montage sont constitués sous la forme de structures métalliques et sont en aluminium, en un alliage d'aluminium ou en des structures stratifiées, les couches individuelles de la structure stratifiée comprenant une ou plusieurs couches en aluminium, en un alliage d'aluminium ou en d'autres métaux comme Cu, Zr, Mg, Ti ou Sc.

43. Composant suivant la revendication 42,
dans lequel les épaisseurs h de couche des structures métalliques sont choisies dans l'intervalle de 1 % < h/λ < 15 %.

44. Composant suivant la revendication 42 ou 43,
dans lequel il est prévu des couches de passivation sur les structures métalliques.

45. Composant suivant l'une des revendications 1 à 44,
dans lequel le potentiel de référence vis-à-vis duquel la au moins une branche parallèle est montée est un potentiel de référence intérieur flottant librement.
